# EUROPEAN PATENT SPECIFICATION

(11) **EP 4 287 415 B1**
(45) Date of publication and mention of the grant of the patent: **08.04.2026**
(21) Application number: 23168529.8
(22) Date of filing: 18.04.2023
(51) Int. Cl.: H01R 13/631, H01R 13/635, H01R 13/703, H01R 13/71, G09F 9/302, G09F 9/33

(54) **PLUG-IN CONNECTION DEVICE OF LED DISPLAY DEVICE, AND LED DISPLAY DEVICE**
STECKVERBINDUNGSVORRICHTUNG EINER LED-ANZEIGEVORRICHTUNG UND LED-ANZEIGEVORRICHTUNG
DISPOSITIF DE CONNEXION ENFICHABLE DE DISPOSITIF D'AFFICHAGE À DEL ET DISPOSITIF D'AFFICHAGE À DEL

(30) Priority: 30.05.2022 CN 202210603436
(43) Date of publication of application: 06.12.2023
(73) Proprietor: Leyard Optoelectronic Co., Ltd., Beijing 100091 (CN)
(72) Inventor: Cao, Linhua, Beijing, 100091 (CN); An, Guoliang, Beijing, 100091 (CN); Liu, Zhiyong, Beijing, 100091 (CN)
(74) Representative: Fuchs Patentanwälte Partnerschaft mbB

(56) References cited:
- CN-A- 102 412 490
- CN-A- 113 036 520

## Description

### Cross-Reference to Related Application

The present invention claims the priority to Chinese Patent Application No. 202210603436.4, filed to the Chinese Patent Office on May 30, 2022 and entitled "Plug-in Connection Device for LED Display Device, and LED Display Device".

### Technical Field

The present invention relates to the technical field of LED display, and particularly relates to a plug-in connection device for an LED display device, and the LED display device.

### Background

In the technical field of light-emitting diode (LED) display, an LED display device includes a plurality of display units arranged side by side. When two adjacent display units are assembled, flexible and independent power lines and data lines are generally used for connection.

In this way, wiring is complicated when the power lines are connected, and if the power lines are connected with an external power supply, a safety accident is likely to occur when the display units are continuously assembled.

Examples of a Connecting Device for LED Box Body and LED Display Device according to the prior art are described in CN113036520A; and examples of a Two-section Rotary Socket according to the prior art are described in CN102412490A.

### Summary

The main objective of the present invention is to provide a plug-in connection device for an LED display device, and the LED display device, so as to solve the problem of a safety accident is likely to occur when the display units are continuously assembled because a power line is connected with an external power supply in the related art. In order to achieve the above objective a plug- in connection device for an LED display device according to claim 1 is provided. In some embodiments, the input electrically conductive terminal and the output electrically conductive terminal are disconnected, the switch includes a connecting conductor arranged in the first base and an operational key driving the connecting conductor to move, and the connecting conductor connects the input electrically conductive terminal with the output electrically conductive terminal when moving to cooperate with both the input electrically conductive terminal and the output electrically conductive terminal.

In some embodiments, the first receptacle assembly further includes an external socket arranged on the PCB, and the external socket is electrically connected with the output electrically conductive terminal.

In some embodiments, the first plug assembly further includes a guide structure arranged between the second base and the insulating substrate, the guide structure includes a guide hole extending in the moving direction of the insulating substrate and a guide column capable of being inserted into the guide hole, one of the guide hole and the guide column is arranged on the second base, and the other of the guide hole and the guide column is arranged on the insulating substrate.

In some embodiments, the first plug assembly further includes a first elastic member arranged between the second base and the second electrically conductive member, and the first elastic member applies an elastic force in a direction away from the first base to the second electrically conductive member; and/or, the second electrically conductive member cooperates with the first electrically conductive member in a point-surface contact manner when the second electrically conductive member is at the first connection position.

In some embodiments, the first receptacle assembly further includes a first push member spaced apart from the first base, the first driving member includes a first driving rod movably disposed on the second base in a penetrating manner and a first lever plate swingably arranged in the second base, a first end of the first lever plate abuts against the first driving rod, a second end of the first lever plate abuts against the second electrically conductive member, and the first push member is movably arranged and is able to push the first driving rod to move, so as to drive the first lever plate to swing and to drive the second electrically conductive member to switch from the first disconnection position to the first connection position.

In some embodiments, the first receptacle assembly further includes a first mounting base spaced apart from the first base and a second elastic member arranged in the first mounting base, the first push member is movably located in the first mounting base, the second elastic member applies an elastic force towards the first driving rod to the first push member, and the first push member is able to cooperate with the first driving rod in a point-surface contact manner.

In some embodiments, the plug-in connection device further includes a signal plug-in connection structure, wherein the signal plug-in connection structure includes: a second receptacle assembly including a third base and a first signal transmission member arranged on the third base; and a second plug assembly including a fourth base, a second signal transmission member movably arranged on the fourth base, and a second driving member movably arranged on the fourth base, wherein the second signal transmission member has a second connection position penetrating out of the fourth base and being in contact conduction with the first signal transmission member and a second disconnection position retracted into the fourth base and separated from the first signal transmission member, and the second driving member moves to drive the second signal transmission member to move towards or away from the first signal transmission member so as to make the second signal transmission member switch between the second connection position and the second disconnection position.

In some embodiments, the second plug assembly further includes a third elastic member arranged between the fourth base and the second signal transmission member, and the third elastic member applies an elastic force in a direction away from the third base to the second signal transmission member; and/or, the second signal transmission member cooperates with the first signal transmission member in a point-surface contact manner when the second signal transmission member is at the second connection position.

In some embodiments, the second receptacle assembly further includes a second push member spaced apart from the third base, the second driving member includes a second driving rod movably disposed on the fourth base in a penetrating manner and a second lever plate swingably arranged in the fourth base, a first end of the second lever plate abuts against the second driving rod, a second end of the second lever plate abuts against the second signal transmission member, and the second push member is movably arranged and is able to push the second driving rod to move, so as to drive the second lever plate to swing and to drive the second signal transmission member to switch from the second disconnection position to the second connection position; and the second receptacle assembly further includes a second mounting base spaced apart from the third base and a fourth elastic member arranged in the second mounting base, the second push member is movably located in the second mounting base, the fourth elastic member applies an elastic force towards the second driving rod to the second push member, and the second push member is able to cooperate with the second driving rod in a point-surface contact manner.

According to another aspect of the present invention, provided is an LED display device. The LED display device includes a first display unit, a second display unit and a plug-in connection device, wherein the first display unit and the second display unit are arranged side by side, the plug-in connection device is the above plug-in connection device for an LED display device, the first receptacle assembly of the plug-in connection device is mounted on a side edge of the first display unit adjacent to the second display unit, and the first plug assembly of the plug-in connection device is mounted on a side edge of the second display unit adjacent to the first display unit.

According to another aspect of the present invention, provided is an LED display device. The LED display device includes a first display unit, a second display unit, a third display unit, a fourth display unit and a plug-in connection device, wherein the first display unit, the second display unit, the third display unit and the fourth display unit are arranged in an array and distributed sequentially in a circumferential direction, the plug-in connection device is the above plug-in connection device for an LED display device, the first receptacle assembly of the plug-in connection device is mounted on a side edge of the first display unit adjacent to the second display unit, the first plug assembly of the plug-in connection device is mounted on a side edge of the second display unit adjacent to the first display unit; the second receptacle assembly of the plug-in connection device is mounted on the side edge of the first display unit adjacent to the second display unit, and the second plug assembly of the plug-in connection device is mounted on the side edge of the second display unit adjacent to the first display unit; and/or, the second receptacle assembly of the plug-in connection device is mounted on a side edge of the first display unit adjacent to the fourth display unit, and the second plug assembly of the plug-in connection device is mounted on a side edge of the fourth display unit adjacent to the first display unit.

Applying the technical solution of the present invention, the plug-in connection device for the LED display device includes the power supply plug-in connection structure. The power supply plug-in connection structure includes the first receptacle assembly and the first plug assembly. The first receptacle assembly includes the first base, the first electrically conductive member arranged on the first base, and the switch, wherein the switch is able to make the first electrically conductive member in the connected state or the disconnected state. The first plug assembly includes the second base, the second electrically conductive member movably arranged on the second base, and the first driving member movably arranged on the second base. The second electrically conductive member has the first connection position penetrating out of the second base and being in contact conduction with the first electrically conductive member and the first disconnection position retracted into the second base and separated from the first electrically conductive member, and the first driving member moves to drive the second electrically conductive member to move towards or away from the first electrically conductive member so as to make the second electrically conductive member switch between the first connection position and the first disconnection position. The first receptacle assembly of the plug-in connection device for the LED display device may be mounted on an adjacent side edge of two adjacent display units, and the first plug assembly of the plug-in connection device for the LED display device may be mounted on the other adjacent side edge of the two adjacent display units. When the two adjacent display units are assembled together, the first driving member moves to drive the second electrically conductive member to move towards the first electrically conductive member so as to make the second electrically conductive member switch to the first connection position, and in this case, the first receptacle assembly and the first plug assembly are in plug-in connection with each other. In this way, the first electrically conductive member is electrically connected with a power line by the plug-in connection of the first receptacle assembly and the first plug assembly while the two adjacent display units are assembled, thereby simplifying wiring operation to make the power line connection simple, assembly of the two adjacent display units is easier, and assembly efficiency is improved. When the two adjacent display units are disassembled, the first driving member moves to drive the second electrically conductive member to move away from the first electrically conductive member so as to make the second electrically conductive member switch from the first connection position to the first disconnection position, in this case, the first receptacle assembly and the first plug assembly are separated, and the two adjacent display units may be detached. Moreover, the first electrically conductive member is connected with an external power supply, and the first electrically conductive member is able to be in the disconnected state by the switch when the display units are continuously assembled, such that the assembled display units are not energized, thereby reducing possibility of a safety accident. Thus, the technical solution of the invention solves the problem of a safety accident is likely to occur when the display unit are continuously assembled because a power line is connected with an external power supply in the related art.

### Brief Description of the Drawings

The accompanying drawings, forming a part of the invention, of the description serve to provide a further understanding of the present invention, and the illustrative embodiments of the present invention and the description of the illustrative embodiments serve to explain the present invention and are not to be construed as unduly limiting the present invention. In the drawings:
Fig. 1 is a schematic three-dimensional structural diagram of an embodiment of an LED display device according to the present invention;
Fig. 2 is a schematic side view of the LED display device of Fig. 1;
Fig. 3 is a schematic sectional view in direction A-A of the LED display device of Fig. 2;
Fig. 4 is a schematic enlarged partial diagram at portion C of the LED display device of Fig. 3;
Fig. 5 is a schematic sectional view in direction B-B of the LED display device of Fig. 2;
Fig. 6 is a schematic enlarged partial diagram at portion D of the LED display device of Fig. 5;
Fig. 7 is a schematic circuit diagram of an embodiment of a plug-in connection device for the LED display device according to the present invention;
Fig. 8 is a schematic front view of a first plug assembly of the plug-in connection device for the LED display device of Fig. 7;
Fig. 9 is a schematic side view of the first plug assembly of Fig. 8;
Fig. 10 is a schematic sectional view in direction E-E of the first plug assembly of Fig. 9;
Fig. 11 is a schematic sectional view in direction F-F of the first plug assembly of Fig. 9;
Fig. 12 is a schematic top view of the first plug assembly of Fig. 8;
Fig. 13 is a schematic front view of a first receptacle assembly of the plug-in connection device for the LED display device of Fig. 7;
Fig. 14 is a schematic sectional view in direction G-G of the first receptacle assembly of Fig. 13;
Fig. 15 is a schematic side view of the first receptacle assembly of Fig. 13;
Fig. 16 is a schematic sectional view in direction H-H of the first receptacle assembly of Fig. 15;
Fig. 17 is a schematic sectional view showing that an external power supply plug is plugged into an external socket of the first receptacle assembly of Fig. 13;
Fig. 18 is a schematic bottom view of the first receptacle assembly of Fig. 13;
Fig. 19 is a schematic front view of a second plug assembly of the plug-in connection device for the LED display device of Fig. 7;
Fig. 20 is a schematic side view of the second plug assembly of Fig. 19;
Fig. 21 is a schematic sectional view in direction I-I of the second plug assembly of Fig. 20;
Fig. 22 is a schematic sectional view in direction J-J of the second plug assembly of Fig. 20;
Fig. 23 is a schematic front view of a second receptacle assembly of the plug-in connection device for the LED display device of Fig. 7; and
Fig. 24 is a schematic bottom view of the second receptacle assembly of Fig. 23.

The above figures include the following reference numerals:
10. first receptacle assembly; 11. first base; 12. first electrically conductive member; 121. printed circuit board (PCB); 122. input electrically conductive terminal; 123. output electrically conductive terminal; 124. external socket; 13. switch; 131. operational key; 14. first mounting base; 15. first push member; 16. second elastic member; 20. first plug assembly; 21. second base; 22. second electrically conductive member; 221. insulating substrate; 222. electrically conductive column; 23. first driving member; 231. first driving rod; 232. first lever plate; 241. guide hole; 242. guide column; 25. first elastic member; 30. second receptacle assembly; 31. third base; 32. first signal transmission member; 33. second mounting base; 34. second push member; 35. fourth elastic member; 40. second plug assembly; 41. fourth base; 42. second signal transmission member; 43. second driving member; 44. third elastic member; 431. second driving rod; 432. second lever plate; 51. first display unit; 52. second display unit; 53. third display unit; 54. fourth display unit; and 62. external power supply plug.

### Detailed Description of the Embodiments

The technical solutions of embodiments of the present invention will be described below clearly and comprehensively in conjunction with accompanying drawings of the embodiments of the present invention.

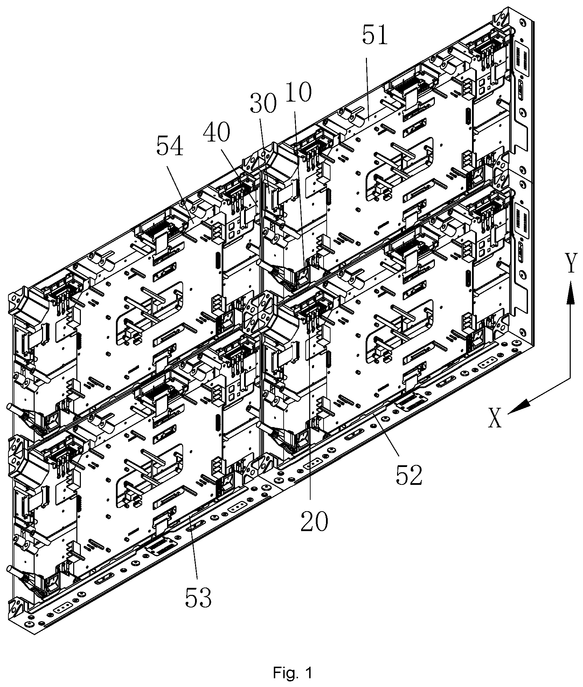

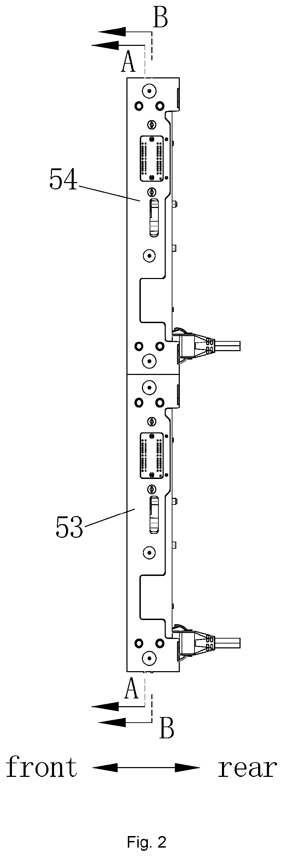

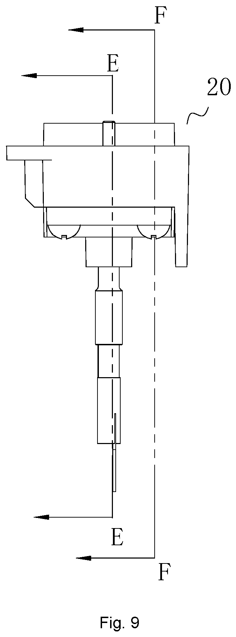

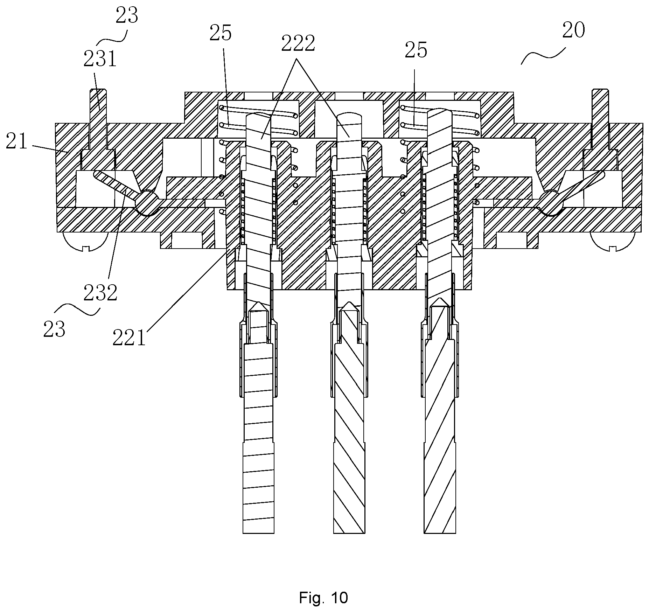

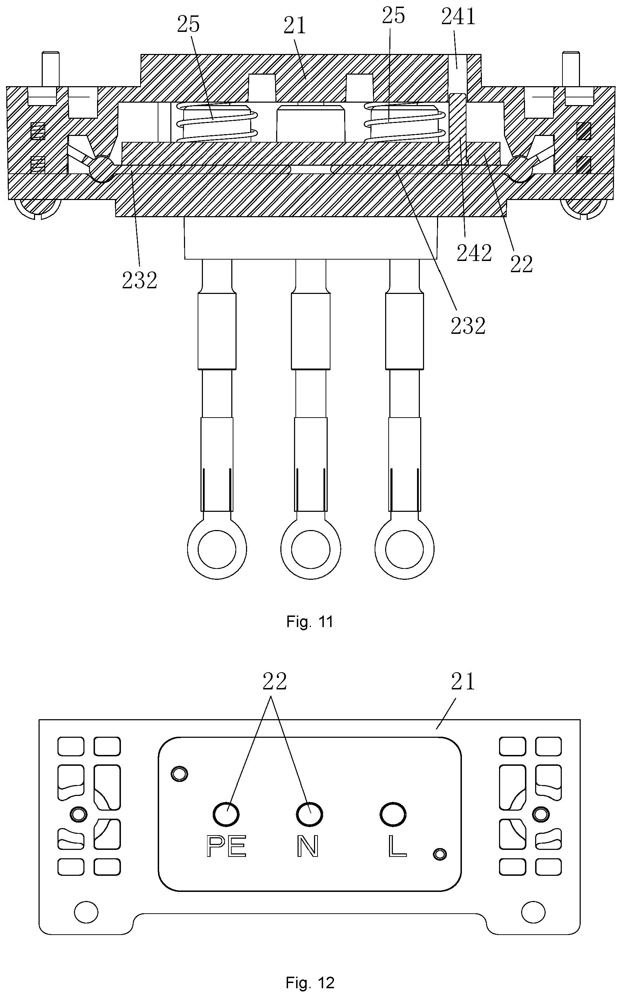

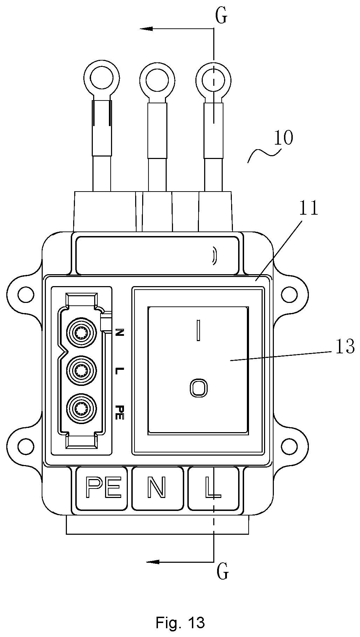

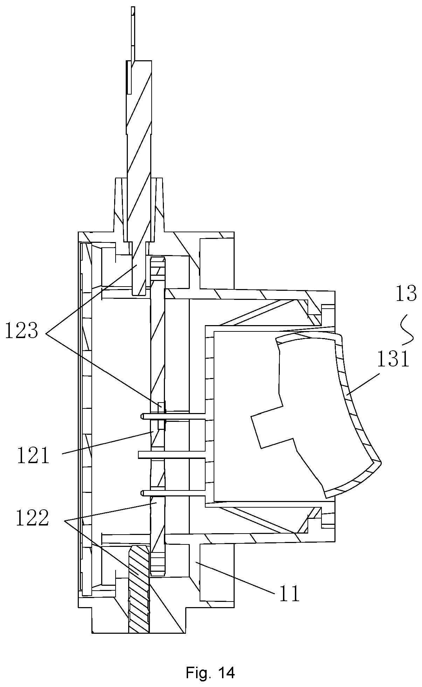

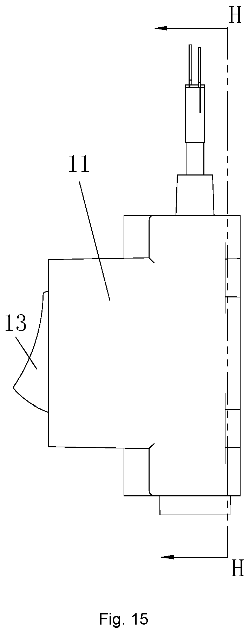

As shown in Figs. 1-15, a plug-in connection device for an LED display device according to an embodiment includes a power supply plug-in connection structure. The power supply plug-in connection structure includes a first receptacle assembly 10 and a first plug assembly 20. The first receptacle assembly 10 includes a first base 11, a first electrically conductive member 12 arranged on the first base 11, and a switch 13. The switch 13 is able to make the first electrically conductive member 12 in a connected state or a disconnected state. The first plug assembly 20 includes a second base 21, a second electrically conductive member 22 movably arranged on the second base 21, and a first driving member 23 movably arranged on the second base 21. In the embodiment, the second electrically conductive member 22 has a first connection position penetrating out of the second base 21 and being in contact conduction with the first electrically conductive member 12 and a first disconnection position retracted into the second base 21 and separated from the first electrically conductive member 12, and the first driving member 23 moves to drive the second electrically conductive member 22 to move towards or away from the first electrically conductive member 12 so as to make the second electrically conductive member 22 switch between the first connection position and the first disconnection position.

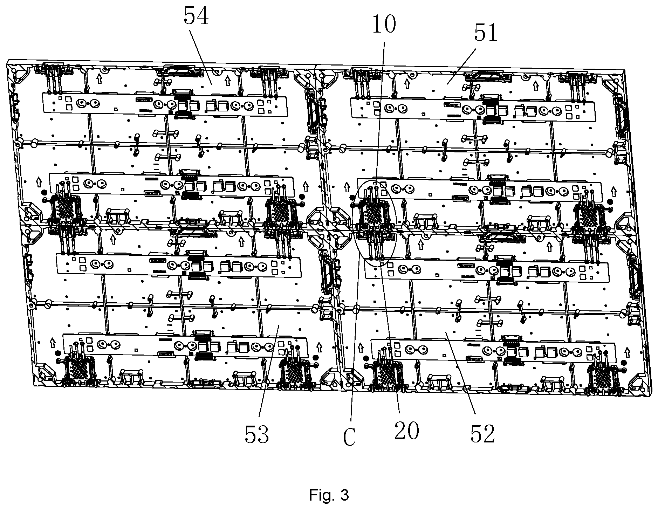

Applying the technical solution of the embodiment, the first receptacle assembly 10 of the plug-in connection device for the LED display device may be mounted on an adjacent side edge of two adjacent display units, and the first plug assembly 20 of the plug-in connection device for the LED display device may be mounted on the other adjacent side edge of the two adjacent display units. When the two adjacent display units are assembled together, the first driving member 23 moves to drive the second electrically conductive member 22 to move towards the first electrically conductive member 12 so as to make the second electrically conductive member 22 switch to the first connection position, and in this case, the first receptacle assembly 10 and the first plug assembly 20 are in plug-in connection with each other. In this way, the first electrically conductive member 12 is electrically connected with a power line by the plug-in connection of the first receptacle assembly 10 and the first plug assembly 20 while the two adjacent display units are assembled, thereby simplifying wiring operation to make the power line connection simple, assembly of the two adjacent display units is easier, and assembly efficiency is improved. When the two adjacent display units are disassembled, the first driving member 23 moves to drive the second electrically conductive member 22 to move away from the first electrically conductive member 12 so as to make the second electrically conductive member 22 switch from the first connection position to the first disconnection position, in this case, the first receptacle assembly 10 and the first plug assembly 20 are separated, and the two adjacent display units may be detached. Moreover, the first electrically conductive member 12 is connected with an external power supply, and the first electrically conductive member 12 is able to be in the disconnected state by the switch 13 when the display units are continuously assembled, such that the assembled display units are not energize, thereby reducing possibility of a safety accident. Thus, the technical solution of the embodiment solves the problem of a safety accident is likely to occur when the display units are continuously assembled because a power line is connected with an external power supply in the related art. In this way, the combination and separation of power input of the individual display units is able to be controlled. The two adjacent display units above may be a first display unit 51 and a second display unit 52 in Fig. 3. The switch 13 is preferably a rocker switch.

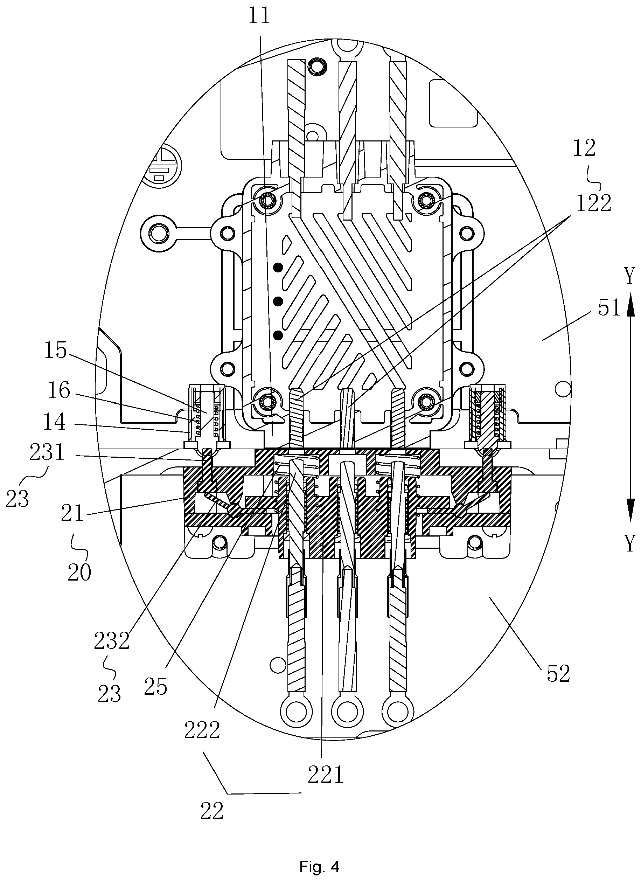

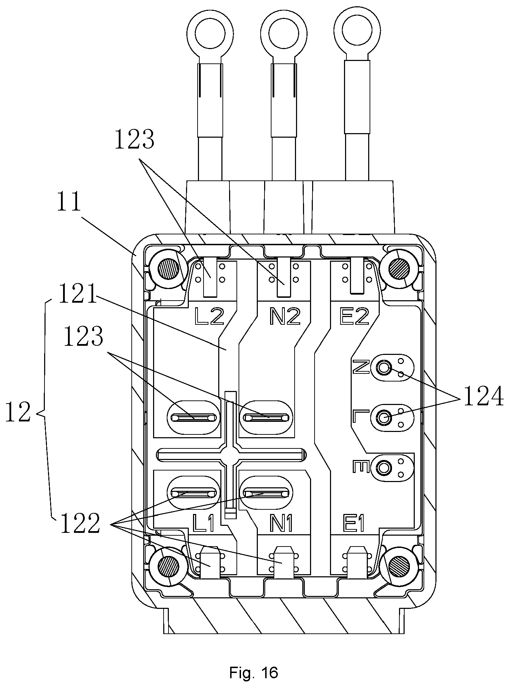

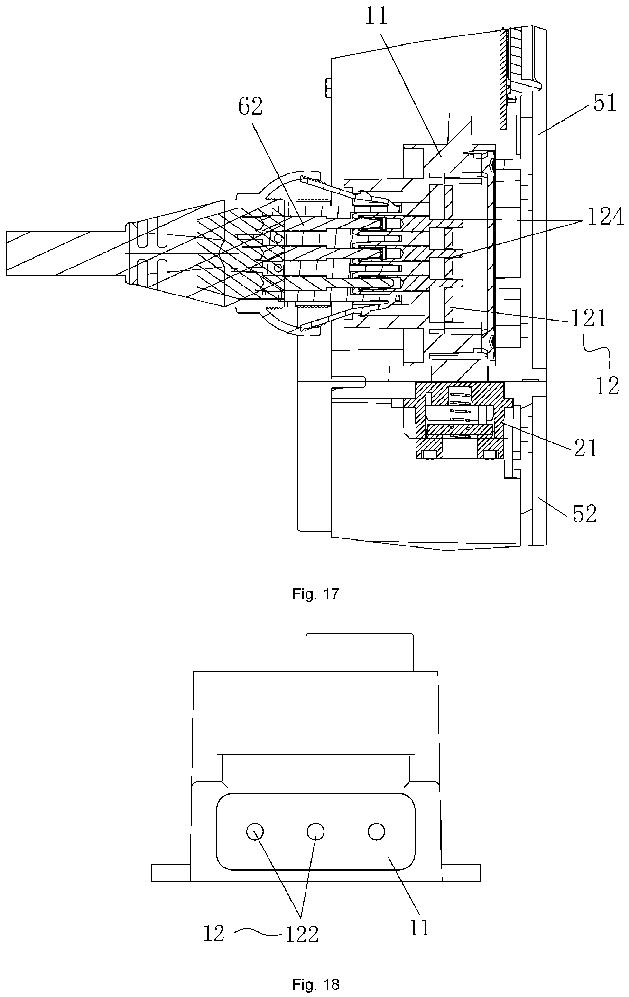

As shown in Figs. 4, 7, and 13-18, the first electrically conductive member 12 includes a printed circuit board (PCB) 121 mounted in the first base 11, and an input electrically conductive terminal 122 and an output electrically conductive terminal 123 arranged on the PCB 121. The input electrically conductive terminal 122 and the output electrically conductive terminal 123 are disconnected. The switch 13 includes a connecting conductor arranged in the first base 11 and an operational key 131 driving the connecting conductor to move, and the connecting conductor connects the input electrically conductive terminal 122 with the output electrically conductive terminal 123 when moving to cooperate with both the input electrically conductive terminal 122 and the output electrically conductive terminal 123. In this way, acting as a carrier for the input electrically conductive terminal 122 and the output electrically conductive terminal 123, the PCB 121 facilitates the connecting conductor being electrically connected with the input electrically conductive terminal 122 and the output electrically conductive terminal 123 at the same time. When the connecting conductor moves to separate from the input electrically conductive terminal 122 and the output electrically conductive terminal 123, the input electrically conductive terminal 122 and the output electrically conductive terminal 123 are disconnected, to make the first electrically conductive member 12 in the disconnected state. Since both the input electrically conductive terminal 122 and the output electrically conductive terminal 123 are integrated on the PCB 121, component parts of the first receptacle assembly 10 are smaller, an overall structure is simple, a process assembly is facilitated, thereby production costs is reduced, which is suitable for medium and small batch production.

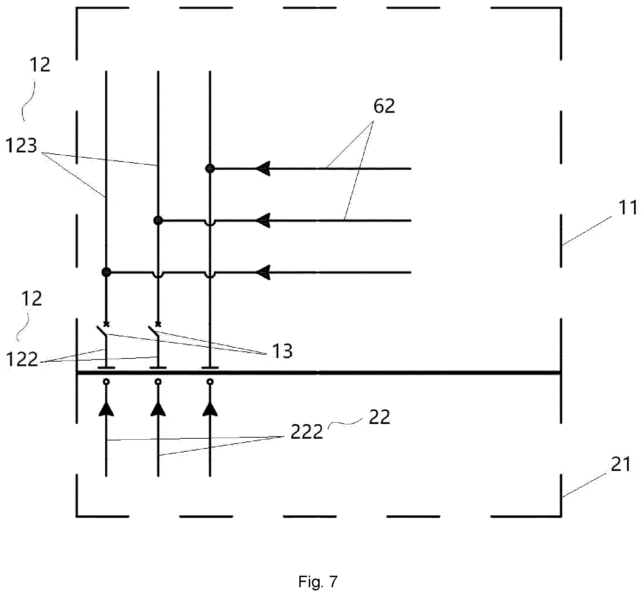

As shown in Figs. 7, and 13b to 17, in order to facilitate plugging of the external power supply plug 62 into the first receptacle assembly 10, the first receptacle assembly 10 further includes an external socket 124 arranged on the PCB 121, and the external socket 124 is electrically connected with the output electrically conductive terminal 123. In this way, the external power supply plug 62 is able to be plugged into the external socket 124 for contact conduction, such that the first electrically conductive member 12 is able to be connected with the external power supply. The external socket 124 may be integrated on the PCB 121, such that the overall structural of the first receptacle assembly 10 is simple.

Specifically, the external power supply plug 62 includes a power external line copper pin, and the first receptacle assembly 10 further includes a power supply crown spring cooperating with the power external line copper pin in a plug-in connection contact manner.

As shown in Figs. 4-10, the second electrically conductive member 22 includes an insulating substrate 221 movably arranged on the second base 21, and an electrically conductive column 222 arranged in the insulating substrate 221. The electrically conductive column 222 is floatably arranged relative to the insulating substrate 221 in a moving direction of the insulating substrate 221. The first driving member 23 moves to drive the insulating substrate 221 to move towards the first electrically conductive member 12 so as to make the electrically conductive column 222 in contact conduction with the input electrically conductive terminal 122. The first driving member 23 moves to drive the insulating substrate 221 to move away from the first electrically conductive member 12 so as to make the electrically conductive column 222 separated from the input electrically conductive terminal 122.

Specifically, the electrically conductive column 222 is fully floated in the insulating substrate 221 by mounting and gap orientation in the insulating substrate 221 and elastic limitation from a post spring in the insulating substrate 221. The electrically conductive column 222 is placed in the insulating substrate 221, then the post spring is placed in the insulating substrate 221, and the insulating substrate 221 is stitched by riveting press closing.

Specifically, the electrically conductive column 222 includes a neutral wire column and a live wire column, and the first plug assembly 20 further includes a grounding column, the live wire column and the grounding column are both parallel to the neutral wire column, and all the neutral wire column, the live wire column and the grounding column penetrate the insulating substrate 221 in a spaced manner. The insulating substrate 221 isolates the neutral wire column, the live wire column, and the grounding column to avoid short circuits. The input electrically conductive terminal 122 includes a first neutral wire terminal and a first live wire terminal, the output electrically conductive terminal 123 includes a second neutral wire terminal and a second live wire terminal, the first plug assembly 20 further includes a grounding terminal, and the grounding terminal is arranged on the PCB and spaced apart from the second neutral wire terminal. In this way, the grounding terminal is further integrated on the PCB. The first driving member 23 moves to drive the insulating substrate 221 to move towards the first electrically conductive member 12 so as to make the neutral wire column in contact conduction with the first neutral wire terminal, the live wire column in contact conduction with the first live wire terminal, and the grounding column in contact conduction with the grounding terminal.

It is to be noted that the second electrically conductive member 22 further includes a flexible neutral wire, a flexible live wire, and a flexible grounding wire electrically connected with the neutral wire column, the live wire column, and the grounding column respectively, the flexible neutral wire, the flexible live wire and the flexible grounding wire are all free to extendable deform to facilitate reciprocal movement of the electrically conductive column 222 with the insulating substrate 221, so as to make the second electrically conductive member 22 switch between the first connection position and the first disconnection position.

Further, the first neutral wire terminal includes a neutral wire copper pin penetrating in the first base 11 and a neutral wire copper sheet arranged on the PCB, the neutral wire copper pin is in welded connection with the neutral wire copper sheet. Similarly, the first live wire terminal includes a live wire copper pin and a live wire copper sheet, and the grounding terminal includes a grounding copper pin and a grounding copper sheet. When the second electrically conductive member 22 is at the first connection position, the neutral wire column of the second electrically conductive member 22 cooperates with the neutral wire copper pin of the first electrically conductive member 12 in a point-surface contact manner, the live wire column of the second electrically conductive member 22 cooperates with the live wire copper pin of the first electrically conductive member 12 in a point-surface contact manner, and the grounding column of the second electrically conductive member 22 cooperates with the grounding copper pin of the first electrically conductive member 12 in a point-surface contact manner.

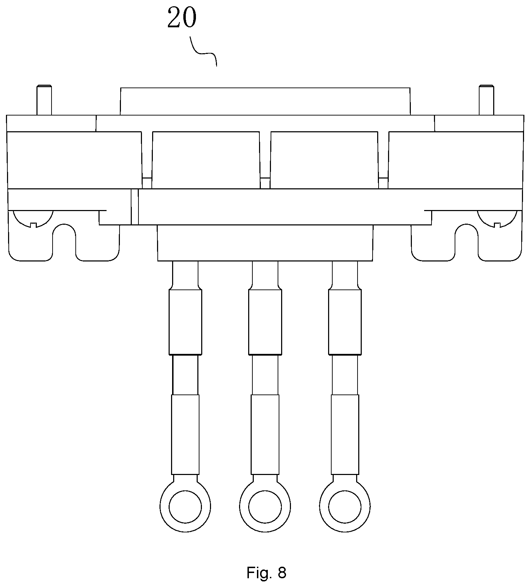

As shown in Figs. 8-11, in order to prevent deflection of the insulating substrate 221 when moving in the second base 21, the first plug assembly 20 further includes a guide structure arranged between the second base 21 and the insulating substrate 221. The guide structure includes a guide hole 241 extending in the moving direction of the insulating substrate 221 and a guide column 242 capable of being inserted into the guide hole 241, the guide hole 241 is arranged on the second base 21, and the guide column 242 is arranged on the insulating substrate 221. In this way, the guide column 242 is fixedly connected with the insulating substrate 221, during the movement of the insulating substrate 221 in the second base 21, since the guide column 242 is able to move in the guide hole 241 along an axis of the guide hole 241, it is defined that the insulating substrate 221 moves only along the axis of the guide hole 241, such that the insulating substrate 221 moves smoothly in the second base 21.

Certainly, in an embodiment not shown in the figures, the guide column is arranged on the second base, and the guide hole is arranged on the insulating substrate.

As shown in Figs. 4, 10 and 11, the first plug assembly 20 further includes a first elastic member 25 arranged between the second base 21 and the second electrically conductive member 22. The first elastic member 25 applies an elastic force in a direction away from the first base 11 to the second electrically conductive member 22. In this way, under the action of the elastic force of the first elastic member 25, the second electrically conductive member 22 floats in the second base 21 in a Y-axis direction of Fig. 4. The second electrically conductive member 22 is quickly separated from the first electrically conductive member 12 since the first elastic member 25 applies the elastic force in the direction away from the first base 11 to the second electrically conductive member 22 during movement of the second electrically conductive member 22 from the first connection position to the first disconnection position. The second electrically conductive member 22 remains in the first disconnection position after the two adjacent display units are disassembled, so as to avoid damage or interference caused by the second electrically conductive member 22 penetrating out of the second base 21. The first elastic member 25 above is a spring or an elastic body. When the first elastic member 25 is a spring, the spring is preferably a compression spring, and in this case, the compression spring is mounted above the insulating substrate. Certainly, in an embodiment not shown in the figures, the spring is preferably a tension spring, and in this case, the tension spring is mounted below the insulating substrate.

In the embodiment, a first avoidance hole for avoiding the electrically conductive column 222 is provided on the second base 21. A first mounting hole for mounting the first elastic member 25 is provided on the second base 21. The first mounting hole is in communication with the first avoidance hole.

As shown in Figs. 4, 10, and 14, the second electrically conductive member 22 cooperates with the first electrically conductive member 12 in a point-surface contact manner when the second electrically conductive member 22 is in the first connection position.

It is to be noted that the second electrically conductive member 22 cooperating with the first electrically conductive member 12 in a point-surface contact manner means that an end of the electrically conductive column 222 of the second electrically conductive member 22 facing the input electrically conductive terminal 122 has a first spherical surface, an end of the input electrically conductive terminal 122 facing the electrically conductive column 222 has a first flat surface or first concave cambered surface, and the contact between the first spherical surface and the first flat surface or first concave cambered surface is point-surface contact. During assembly of the two adjacent display units, the electrically conductive column 222 with the first spherical surface smoothly penetrates out of the second base 21 to cooperate with the input electrically conductive terminal 122 with the first flat surface in a point-surface contact manner, so as to make the second electrically conductive member 22 at the first connection position. During disassembly of the two adjacent display units, the electrically conductive column 222 with the first spherical surface is smoothly retracted into the second base 21 to be separated from the input electrically conductive terminal 122 with the first flat surface, so to make the second electrically conductive member 22 at the first disconnection position.

Specifically, the first avoidance hole for avoiding the electrically conductive column 222 is provided on the second base 21. During assembly the two adjacent display units and movement of the second electrically conductive member 22 from the first disconnection position to the first connection position, after a part of the first spherical surface of the electrically conductive column 222 is in sliding contact with a hole wall of the first avoidance hole, a moving direction of the electrically conductive column 222 is quickly adjusted, such that an axis of the electrically conductive column 222 is parallel to an axis of the first avoidance hole, and then the electrically conductive column 222 smoothly penetrates out of the second base 21 through the first avoidance hole, to cooperate with the input electrically conductive terminal 122 in a point-surface contact manner.

Certainly, in an embodiment not shown in the figures, the first plug assembly further includes a first elastic member arranged between the second base and the second electrically conductive member, and the first elastic member applies an elastic force in a direction away from the first base to the second electrically conductive member. Or the second electrically conductive member cooperates with the first electrically conductive member in a point-surface contact manner when the second electrically conductive member is at the first connection position.

As shown in Figs. 4, 10, and 16, the first receptacle assembly 10 further includes a first push member 15 spaced apart from the first base 11. The first driving member 23 includes a first driving rod 231 movably disposed on the second base 21 in a penetrating manner and a first lever plate 232 swingably arranged in the second base 21. A first end of the first lever plate 232 abuts against the first driving rod 231, a second end of the first lever plate 232 abuts against the second electrically conductive member 22, and the first push member 15 is movably arranged and is able to push the first driving rod 231 to move, so as to drive the first lever plate 232 to swing and to drive the second electrically conductive member 22 to switch from the first disconnection position to the first connection position.

In this embodiment, drive cooperation of the first driving rod 231 and the first lever plate 232 above is similar to a lever principle, so as to make the first driving member 23 drive the second electrically conductive member 22 to move, with much less effort. In order to move the second electrically conductive member 22 more smoothly, two first driving members 23 and two first push members 15 are provided, the two first driving members 23 abut against the two first push members 15 in one-to-one correspondence, the two first driving members 23 are located on two sides of the second electrically conductive member 22 separately. Certainly, in an embodiment not shown in the figures, the number of the first driving member and the first push member may not be limited to two, but may also be one, three or more.

In the embodiment, the first lever plate 232 includes a first plate segment, a rotation shaft and a second plate segment connected in sequence. An obtuse angle is formed between the first plate segment and the second plate segment, the rotation shaft is rotatably arranged in the second base 21, the first plate segment abuts against the first driving rod, and the second plate segment abuts against the second electrically conductive member. The second base 21 includes a base body and a bottom plate covering the base body, a first cambered recess is arranged in the base body, a second cambered recess is arranged on a surface of the bottom plate facing the first cambered recess, and the rotation shaft is clamped between the first cambered recess and the second cambered recess. In this way, the first cambered recess and the second cambered recess both cooperate with a side surface of the rotation shaft surface to surface, to avoid shake during swinging of the first lever plate 232 around an axis of the rotation shaft, so as to make the first lever plate 232 swing more smooth, which improves sensitivity of swinging, and then makes the first lever plate 232 drive the second electrically conductive member 22 more easily to move.

Specifically, the insulating substrate 221 of the second electrically conductive member 22 includes a base body block and a first bump and a second bump arranged on two opposite sides of the base body block. Two first lever plates 232 are provided. The second plate segment of one first lever plate 232 abuts against a lower surface of the first bump, and the second plate segment of the other first lever plate 232 abuts against a lower surface of the second bump.

As shown in Figs. 4, 10, and 14, the first receptacle assembly 10 further includes a first mounting base 14 spaced apart from the first base 11 and a second elastic member 16 arranged in the first mounting base 14. The first push member 15 is movably located in the first mounting base 14, the second elastic member 16 applies an elastic force towards the first driving rod 231 to the first push member 15. In this way, under the action of the elastic force of the second elastic member 16, the first push member 15 floats in the first mounting base 14 in the Y-axis direction of Fig. 4. During movement of the second electrically conductive member 22 from the first disconnection position to the first connection position, since the second elastic member 16 applies the elastic force towards the first driving rod 231 to the first push member 15, the first push member 15 always presses the first driving rod 231 down, to clamp the first driving rod 231 between the first lever plate 232 and the first push member 15, and the first push member 15 pushes the first driving rod 231 to make the first driving rod 231 quickly push the first end of the first lever plate 232 to swing around a rotation axis of the first lever plate. After the two adjacent display units are disassembled and after the first push member 15 is impacted, the first push member is able to retract into the first mounting base 14 to avoid interference caused by the first push member 15 penetrating out of the first mounting base 14.

As shown in Figs. 4, 10 and 14, the first push member 15 is able to cooperate with the first driving rod 231 in a point-surface contact manner. It is to be noted that the first push member 15 being capable of cooperating with the first driving rod 231 in a point-surface contact manner means that an end of the first push member 15 facing the first driving rod 231 has a second spherical surface, an end of the first driving rod 231 facing the first push member 15 has a second flat surface or a second concave cambered surface, and the contact between the second spherical surface and the second flat surface or second concave cambered surface is point-surface contact. The second spherical surface protrudes out of a surface of the first base 11 facing the second base 21, a second avoidance hole for avoiding the first driving rod 231 is further provided on the second base 21, a surface of a side edge of the display unit facing the first base 11 is provided with a first avoidance concave cambered surface for avoiding the second spherical surface, and the second avoidance hole is located in the first avoidance concave cambered surface. When the second electrically conductive member 22 is at the first disconnection position, the end of the first driving rod 231 with the second flat surface extends into the first avoidance concave cambered surface, and the second flat surface is lower than or flush with the surface of the side edge of the display unit facing the first base 11.

The second elastic member 16 above is a spring or an elastic body. The first push member 15 is preferably a first push rod. The first receptacle assembly 10 further includes a first stop ring arranged at an opening of the first mounting base 14, a second stop ring in stop cooperation with the first stop ring is arranged on a side wall of the first push rod, the second spherical surface is able to penetrate out of the first mounting 14 through a central hole of the first stop ring. Gap orientation is performed by the first mounting base 14 and the second stop ring, elastic limitation is synchronously performed by the second elastic member 16, and the downward elastic press of the second elastic member 16 and tail gap orientation of the first push rod are ensured by the second stop ring, and the first push rod completely floats in the first mounting base 14.

During assembly of the two adjacent display units and movement of the second electrically conductive member 22 from the first disconnection position to the first connection position, the second spherical surface of the first push member 15 cooperates directly with the second flat surface of the first driving rod 231 in a point-surface contact manner, or the second spherical surface of the first push member 15 moves on the surface of the side edge of the display unit facing the first base 11, and smoothly slides into the first avoidance concave cambered surface to cooperate with the second flat surface of the first driving rod 231 in a point-surface contact manner, to make the first driving rod 231 down downward relative to the first base 11 and press the first end of the first lever plate 232 down so as to make the first end of the first lever plate 232 swing around the rotation axis of the first lever plate, the second end of the first lever plate 232 pushes the second electrically conductive member 22 to move upward relative to the second base 21 to make the second electrically conductive member 22 at the first connection position.

During disassembly of two adjacent display units and movement of the second electrically conductive member 22 from the first connection position to the first disconnection position, a part of the second spherical surface of the first push member 15 slides on the first avoidance concave cambered surface and is gradually separated from the second flat surface of the first driving rod 231, and when impacted, the second spherical surface of the first push member 15 is able to quickly retract into the first mounting base 14 to avoid interference with the second base 21, so as to improve the smoothness of a disassembly process. After the first end of the first lever plate 232 is pushed upward, the end of the first driving rod 231 with the second flat surface re-extends into the first avoidance concave cambered surface. Moreover, the electrically conductive post 222 with the first spherical surface smoothly retracts into the second base 21 to be separated from the input electrically conductive terminal 122 with the first flat surface, so as to make the second electrically conductive member 22 at the first disconnection position.

During assembly of the above two adjacent display units, the second electrically conductive member 22 is able to float in the second base 21 in the Y-axis direction of Fig. 4, and the second electrically conductive member 22 is able to smoothly cooperate with the first electrically conductive member 12 in a point-surface contact manner; and the first push member 15 is able to float in the first mounting base 14 in the Y-axis of Fig. 4, and the first push member 15 is able to smoothly cooperate with the first driving rod 231 in a point-surface contact manner, such that no interference exists between the first plug assembly 20 and the first receptacle assembly 10, and the first plug assembly 20 is able to be quickly plugged into the first receptacle assembly 10. Similarly, the first plug assembly 20 is able to be quickly separated from the first receptacle assembly 10 during disassembly of the two adjacent display units. In this way, the first plug assembly 20 and the first receptacle assembly 10 may be automatically connected, such that the power supplies on the two display units may be automatically electrically connected without manually plugging the first plug assembly 20 by field personnel, so as to facilitate the assembly or disassembly of the two display units in the Y-axis of Fig. 4 by the field personnel.

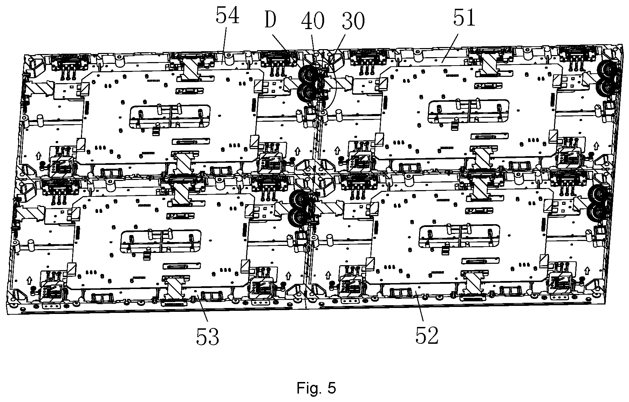

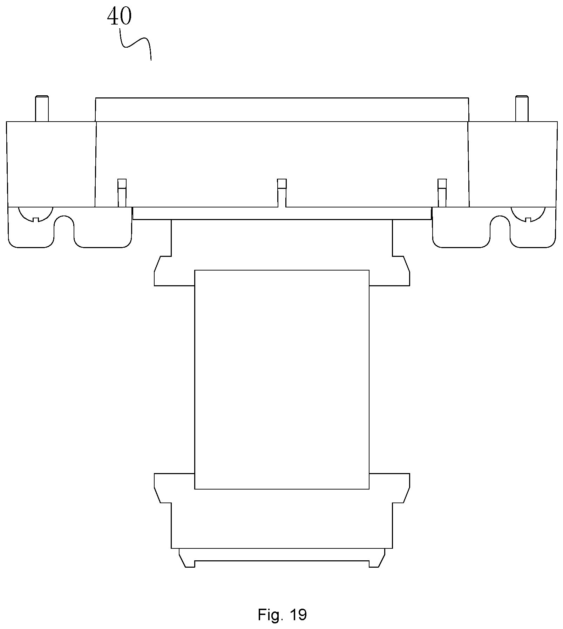

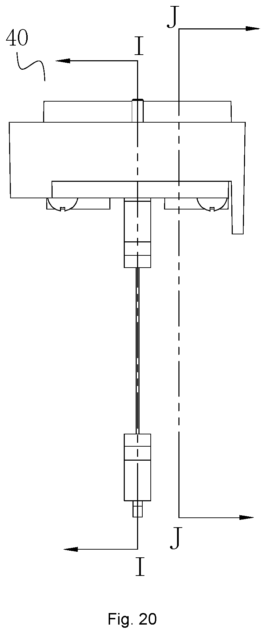

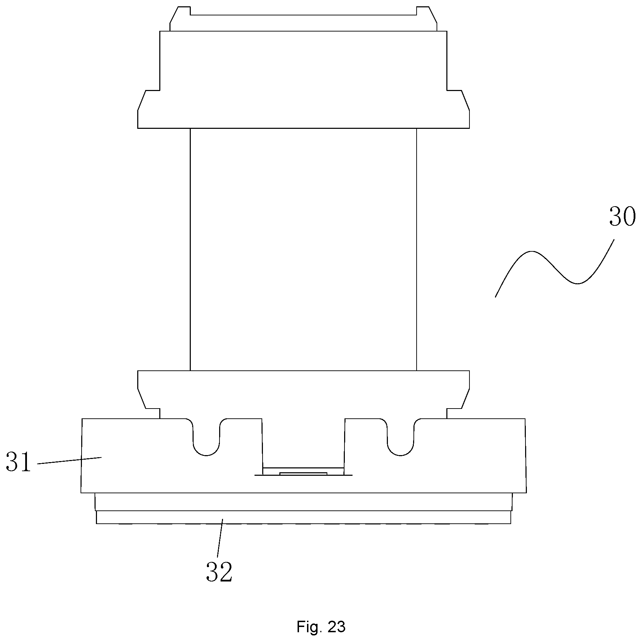

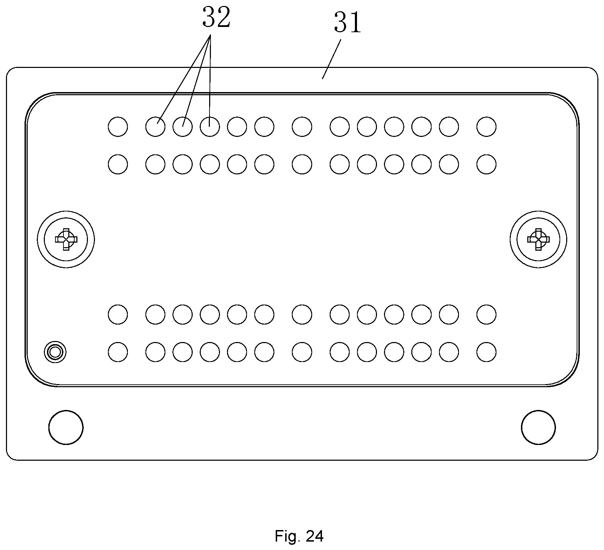

As shown in Figs. 5, 6, and 19-24, the plug-in connection device further includes a signal plug-in connection structure. The signal plug-in connection structure includes a second receptacle assembly 30 and a second plug assembly 40. The second receptacle assembly 30 includes a third base 31 and a first signal transmission member 32 arranged on the third base 31. The second plug assembly 40 includes a fourth base 41, a second signal transmission member 42 movably arranged on the fourth base 41, and a second driving member 43 movably arranged on the fourth base 41. In the embodiment, the second signal transmission member 42 has a second connection position penetrating out of the fourth base 41 and being in contact conduction with the first signal transmission member 32 and a second disconnection position retracted into the fourth base 41 and separated from the first signal transmission member 32, and the second driving member 43 moves to drive the second signal transmission member 42 to move towards or away from the first signal transmission member 32 so as to make the second signal transmission member 42 switch between the second connection position and the second disconnection position. The second receptacle assembly 30 of the plug-in connection device for the LED display device may be mounted on an adjacent side edge of two adjacent display units, and the second plug assembly 40 of the plug-in connection device for the LED display device may be mounted on the other adjacent side edge of the two adjacent display units. When the two adjacent display units are assembled together, a second driving member 43 moves to drive the second signal transmission member 42 to move towards the first signal transmission member 32 so as to make the second signal transmission member 42 switch to the second connection position, and in this case, the second receptacle assembly 30 and the second plug assembly 40 are in plug-in connection to each other. In this way, while the two adjacent display units are assembled, the two adjacent display units are powered on by plug-in connection of the first receptacle assembly 10 and the first plug assembly 20, signal transmission of the two adjacent display units is achieved by plug-in connection of the second receptacle assembly 30 and the second plug assembly 40, so as to simplify wiring operation to make the connection of the power line and the signal line simple, assembly of the two adjacent display units is easier, and assembly efficiency is improved. The two adjacent display units above may be a first display unit 51 and a fourth display unit 54 in Fig. 5.

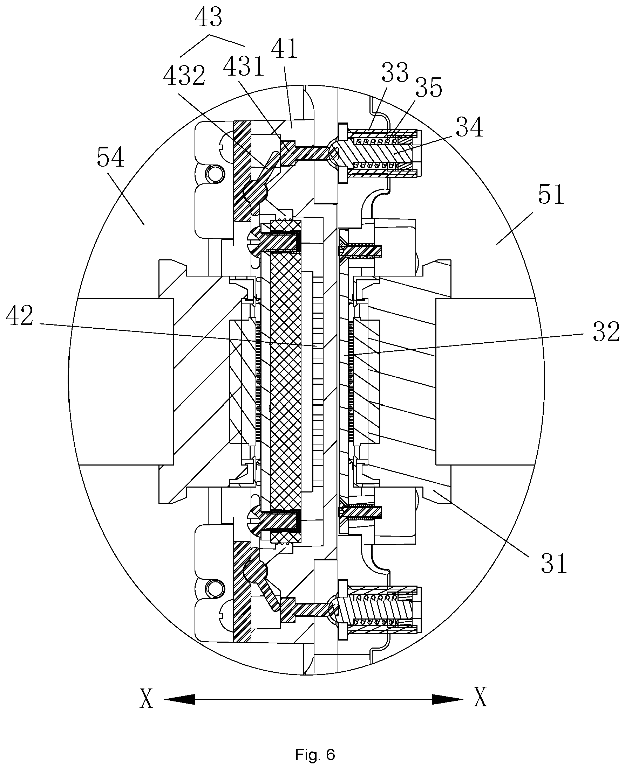

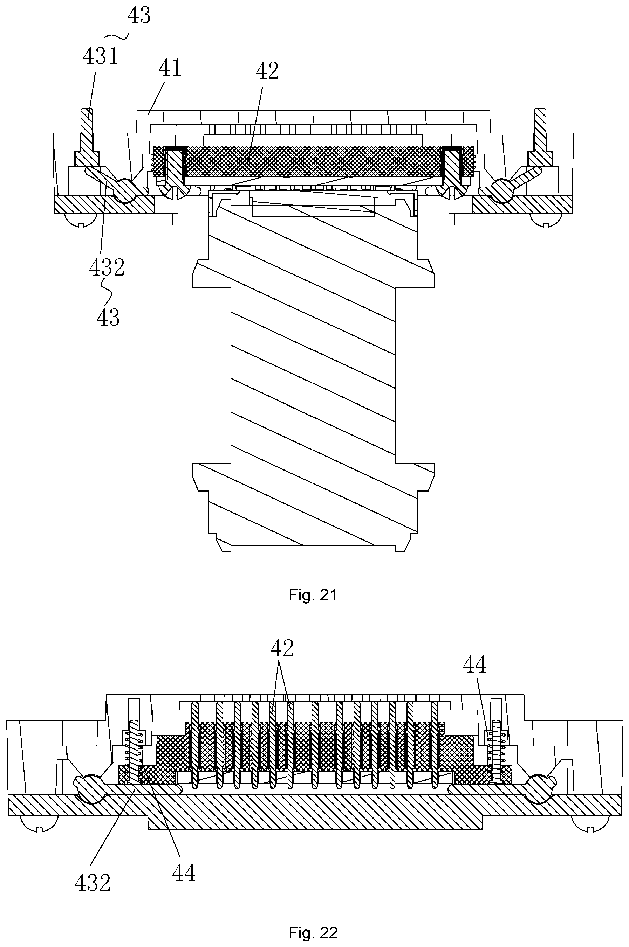

As shown in Figs. 6, 21 and 22, the second plug assembly 40 further includes a third elastic member 44 arranged between the fourth base 41 and the second signal transmission member 42, and the third elastic member 44 applies an elastic force in a direction away from the third base 31 to the second signal transmission member 42. In this way, under the action of the elastic force of the third elastic member 44, the second signal transmission member 42 floats in the fourth base 41 in an X-axis direction of Fig. 6. The second signal transmission member 42 is quickly separated from the first signal transmission member 32 since the third elastic member 44 applies the elastic force in the direction away from the third base 31 to the second signal transmission member 42 during movement of the second signal transmission member 42 from the second connection position to the second disconnection position. The second signal transmission member 42 is able to remain in the second disconnection position after the two adjacent display units are disassembled, so as to avoid damage or interference caused by the second signal transmission member 42 penetrating out of the fourth base 41. The third elastic member 44 above is a spring or an elastic body. When the third elastic member 44 is a spring, the spring is preferably a compression spring, and in this case, the compression spring in Fig. 22 is mounted above an insulating body (as shown in the following). Certainly, in an embodiment not shown in the figures, the spring is preferably a tension spring, and in this case, the tension spring is mounted below the insulating body.

In the embodiment, a third avoidance hole for avoiding a signal pin is provided on the fourth base 41. A second mounting hole for mounting the third elastic member 44 is provided on the fourth base 41. A guide structure is arranged between the fourth base 41 and the insulating body, and the guide structure has the same structure as the guide structure between the second base 21 and the insulating substrate 221.

As shown in Figs. 6 and 22, the first signal transmission member 32 includes a first signal PCB, a surface of a side of the first signal PCB facing the second signal transmission member 42 is an immersion-gold surface. The second signal transmission member 42 includes the insulating body movably arranged on the fourth base 41 and the signal pin arranged in the insulating body. The signal pin is floatably arranged relative to the insulating body in a moving direction of the insulating body. The second driving member 43 moves to drive the insulating body to move towards the first signal transmission member 32 so as to make the signal pin in contact conduction with the first signal transmission member 32. The second driving member 43 moves to drive the insulating body to move away from the first signal transmission member 32 so as to make the signal pin separated from the first signal transmission member 32. The fourth base 41 above includes a housing and a cover plate covering an opening of the housing, a part of the second signal transmission member 42 and a part of the second driving member 43 are located in the housing. The signal pin above is arranged in the insulating body by a signal spring.

In this embodiment, the second plug assembly 40 further includes a flexible circuit plug penetrating the fourth base 41. The second signal transmission member 42 further includes a second signal PCB, a second signal PCB is arranged on a side of the insulating body away from the first signal transmission member 32, the signal pin is electrically connected with the second signal PCB, a side of the second signal PCB away from the insulating body is provided with a PCB receptacle, a flexible circuit plug cooperates with the PCB receptacle in a plug-in connection contact manner, and the flexible circuit plug is electrically connected with the signal pin by the second signal PCB. Since the flexible circuit plug is able to be extend and retracted, the second driving member 43 drives the insulating body to move in the fourth base 41, such that the signal pin is able to move along with the insulating body.

As shown in Figs. 6, 21, and 22, when the second signal transmission member 42 is at the second connection position, the second signal transmission member 42 cooperates with the first signal transmission member 32 in a point-surface contact manner.

It is to be noted that the second signal transmission member 42 cooperating with the first signal transmission member 32 in a point-surface contact manner means that an end of the signal pin of the second signal transmission member 42 facing the first signal PCB has a third spherical surface, the immersion-gold surface of the first signal PCB faces the end of the signal pin, and the contact between the third spherical surface and the immersion-gold surface is point-surface contact. During assembly of the two adjacent display units, the signal pin with the third spherical surface smoothly penetrates out of the fourth base 41 to cooperate with the first signal PCB with the immersion-gold surface in a point-surface contact manner, so as to make the second signal transmission member 42 at the second connection position. During disassembly of the two adjacent display units, the signal pin with the third spherical surface smoothly retracts into the fourth base 41 to be separated from the first signal PCB with the immersion-gold surface, so as to make the second signal transmission member 42 at the second disconnection position.

Specifically, a third avoidance hole for avoiding the signal pin is provided on the fourth base 41. During assembly the two adjacent display units and movement of the second signal transmission member 42 from the second disconnection position to the second connection position, after a part of the third spherical surface of the signal pin is in sliding contact with a hole wall of the third avoidance hole, a moving direction of the signal pin is quickly adjusted, such that an axis of the signal pin is parallel to an axis of the third avoidance hole, and then the signal pin smoothly penetrates out of the fourth base 41 through the third avoidance hole, to cooperate with the first signal PCB in a point-surface contact manner.

Certainly, in an embodiment not shown in the figures, the second plug assembly further includes a third elastic member arranged between the fourth base and the second signal transmission member, and the third elastic member applies an elastic force in a direction away from the third base to the second signal transmission member. Or the second signal transmission member cooperates with the first signal transmission member in a point-surface contact manner when the second signal transmission member is at the second connection position.

As shown in Figs. 6, 21, and 22, the second receptacle assembly 30 further includes a second push member 34 spaced apart from the third base 31. The second driving member 43 includes a second driving rod 431 movably disposed on the fourth base 41 in a penetrating manner and a second lever plate 432 swingably arranged in the fourth base 41, a first end of the second lever plate 432 abuts against the second driving rod 431, a second end of the second lever plate 432 abuts against the second signal transmission member 42, and the second push member 34 is movably arranged and is able to push the second driving rod 431 to move, so as to drive the second lever plate 432 to swing and to drive the second signal transmission member 42 to switch from the second disconnection position to the second connection position.

In this embodiment, drive cooperation of the second driving rod 431 and the second lever plate 432 above is similar to a lever principle, so as to make the second driving member 43 drive the second signal transmission member 42 to move, with much less effort. In order to move the second signal transmission member 42 more smoothly, two second driving members 43 and two second push members 34 are provided, the two second driving members 43 abut against the two second push members 34 in one-to-one correspondence, the two second driving members 43 are located on two sides of the second signal transmission member 42 separately. Certainly, in an embodiment not shown in the figures, the number of the second driving member and the second push member may not be limited to two, but may also be one, three or more.

As shown in Figs. 6, 21, and 22, the second receptacle assembly 30 further includes a second mounting base 33 spaced apart from the third base 31 and a fourth elastic member 35 arranged in the second mounting base 33. The second push member 34 is movably located in the second mounting base 33, the fourth elastic member 35 applies an elastic force towards the second driving rod 431 to the second push member 34. In this way, under the action of the elastic force of the fourth elastic member 35, the second push member 34 is able to float in the second mounting base 33 in the X-axis direction of Fig. 6. During movement of the second signal transmission member 42 from the second disconnection position to the second connection position, since the fourth elastic member 35 applies the elastic force towards the second driving rod 431 to the second push member 34, the second push member 34 always presses the second driving rod 431 down, to clamp the second driving rod 431 between the second lever plate 432 and the second push member 34, and the second push member 34 pushes the second driving rod 431 to make the second driving rod 431 quickly push the first end of the second lever plate 432 to swing around a swinging axis of the second lever plate. After the two adjacent display units are disassembled and the second push member 34 is impacted, the second push member is able to retract into the second mounting base 33 to avoid interference caused by the second push member 34 penetrating out of the second mounting base 33.

As shown in Figs. 6, 21 and 22, the second push member 34 is able to cooperate with the second driving rod 431 in a point-surface contact manner. It is to be noted that the second push member 34 being capable of cooperating with the second driving rod 431 in a point-surface contact manner means that an end of the second push member 34 facing the second driving rod 431 has a fourth spherical surface, an end of the second driving rod 431 facing the second push member 34 has a third flat surface or a third concave cambered surface, and the contact between the fourth spherical surface and the third flat surface or third concave cambered surface is point-surface contact. The fourth spherical surface protrudes out of a surface of the immersion-gold surface of the first signal PCB facing the fourth base 41, a fourth avoidance hole for avoiding the second driving rod 431 is further provided on the fourth base 41, a surface of a side edge of the display unit facing the immersion-gold surface of the first signal PCB is provided with a second avoidance concave cambered surface for avoiding the fourth spherical surface, and the fourth avoidance hole is located in the second avoidance concave cambered surface. When the second signal transmission member 42 is at the second disconnection position, the end of the second driving rod 431 with the third flat surface extends into the second avoidance concave cambered surface, and the third flat surface is lower than or flush with the surface of the side edge of the display unit facing the immersion-gold surface of the first signal PCB.

The fourth elastic member 35 above is a spring or an elastic body. The second push member 34 is preferably a second push rod. The second receptacle assembly 30 further includes a third stop ring arranged at an opening of the second mounting base 33, a fourth stop ring in stop cooperation with the third stop ring is arranged on a side wall of the second push rod, and the fourth spherical surface is able to penetrate out of the second mounting base 33 through a central hole of the third stop ring.

During assembly of the two adjacent display units and movement of the second signal transmission member 42 from the second disconnection position to the second connection position, the fourth spherical surface of the second push member 34 cooperates directly with the third flat surface of the second driving rod 431 in a point-surface contact manner, or the fourth spherical surface of the second push member 34 moves on a surface of the fourth base 41 facing the immersion-gold surface of the first signal PCB, and smoothly slides into the second avoidance concave cambered surface to cooperate with the third flat surface of the second driving rod 431 in a point-surface contact manner, to make the second driving rod 431 move leftward relative to the immersion-gold surface of the first signal PCB and press the first end of the second lever plate 432 down so as to make the first end of the second lever plate 432 swing around the rotation axis of the second lever plate, the second end of the second lever plate 432 pushes the second signal transmission member 42 to move rightward relative to the fourth base 41 to make the second signal transmission member 42 at the second connection position.

During disassembly of two adjacent display units and movement of the second signal transmission member 42 from the second connection position to the second disconnection position, a part of the fourth spherical surface of the second push member 34 slides on the second avoidance concave cambered surface and is gradually separated from the third flat surface of the second driving rod 431, and when impacted, the fourth spherical surface of the second push member 34 is able to quickly retract into the second mounting base 33 to avoid interference with the fourth base 41, so as to improve the smoothness of a disassembly process. After the first end of the second lever plate 432 is pushed rightward, the end of the second driving rod 431 with the third flat surface re-extends into the second avoidance concave cambered surface. Moreover, the signal pin with the third spherical surface smoothly retracts into the fourth base 41 to be separated from the immersion-gold surface of the first signal PCB, so to make the second signal transmission member 42 at the second disconnection position.

During assembly of the two adjacent display units, the second signal transmission member 42 is able to float in the fourth base 41 in the X-axis direction of Fig. 6, and the second signal transmission member 42 is able to smoothly cooperate with the first signal transmission member 32 in a point-surface contact manner; and the second push member 34 is able to float in the second mounting base 33 in the X-axis of Fig. 6, and the second push member 34 is able to smoothly cooperate with the second driving rod 431 in a point-surface contact manner, such that no interference exists between the second receptacle assembly 30 and the second plug assembly 40, and the second plug assembly 40 is quickly plugged into the second receptacle assembly 30. Similarly, the second plug assembly 40 is able to be quickly separated from the second receptacle assembly 30 during disassembly of the two adjacent display units. In this way, the second plug assembly 40 and the second receptacle assembly 30 may be automatically connected, such that signals on the two display units may be automatically transmitted without manually plugging the second plug assembly 40 by the field personnel, so as to facilitate the assembly or disassembly of the two display units by the field personnel in the X-axis of Fig. 6.

In the embodiment, the first plug assembly 20, the first receptacle assembly 10, the second receptacle assembly 30, and the second plug assembly 40 are assembled at screw holes of the corresponding display units by screws.

The invention further provides an LED display device. As shown in Figs. 1-6, the LED display device according to the embodiment includes a first display unit 51, a second display unit 52, and a plug-in connection device. Since the above plug-in connection device for an LED display device solves the problem of a safety accident is likely to occur when the display units are continuously assembled because a power line is connected with an external power supply in the related art, the LED display device having the plug-in connection device solves the same technical problem. The first display unit 51 and the second display unit 52 are arranged side by side, the plug-in connection device is the above plug-in connection device for an LED display device, the first receptacle assembly 10 of the plug-in connection device is mounted on a side edge of the first display unit 51 adjacent to the second display unit 52, and the first plug assembly 20 of the plug-in connection device is mounted on a side edge of the second display unit 52 adjacent to the first display unit 51.

The invention further provides an LED display device. As shown in Figs. 1-6, the LED display device according to the embodiment includes a first display unit 51, a second display unit 52, a third display unit 53, a fourth display unit 54, and a plug-in connection device. The first display unit 51, the second display unit 52, the third display unit 53 and the fourth display unit 54 are arranged in an array and distributed sequentially in a circumferential direction. That is, a longer side edge of the first display unit 51 is adjacent to a longer side edge of the second display unit 52, a shorter side edge of the second display unit 52 is adjacent to a shorter side edge of the third display unit 53, a longer side edge of the third display unit 53 is adjacent to a longer side edge of the fourth display unit 54, and a shorter side edge of the fourth display unit 54 is adjacent to a shorter side edge of the first display unit 51. The plug-in connection device is the above plug-in connection device for an LED display device. Since the above plug-in connection device for an LED display device solves the problem of a safety accident is likely to occur when the display units are continuously assembled because a power line is connected with an external power supply in the related art, the LED display device having the plug-in connection device solves the same technical problem.

As shown in Figs. 1-6, the first receptacle assembly 10 of the plug-in connection device is mounted on a side edge of the first display unit 51 adjacent to the second display unit 52, and the first plug assembly 20 of the plug-in connection device is mounted on a side edge of the second display unit 52 adjacent to the first display unit 51. In this embodiment, the second receptacle assembly 30 of the plug-in connection device is mounted on a side edge of the first display unit 51 adjacent to the fourth display unit 54, and the second plug assembly 40 of the plug-in connection device is mounted on a side edge of the fourth display unit 54 adjacent to the first display unit 51. In this embodiment, the first display unit 51, the second display unit 52, the third display unit 53, and the fourth display unit 54 are all provided with corresponding through holes for avoiding the first plug assembly 20, the first receptacle assembly 10, the second receptacle assembly 30, and the second plug assembly 40, to facilitate plug-in connection of the first plug assembly 20 with the first receptacle assembly 10, and the plug-in connection of second receptacle assembly 30 with the second plug assembly 40.

In this embodiment, the first display unit 51, the second display unit 52, the third display unit 53, and the fourth display unit 54 all include a box and a light panel module arranged at a front side of the box, and the plug-in connection device is mounted at a rear side of the box. Certainly, the plug-in connection device may further be mounted at a rear side of the light panel module.

During assembly of the fourth display unit 54, the third display unit 53, the second display unit 52 and the first display unit 51 in the circumferential direction, the second electrically conductive member 22 is able to float in the second base 21 in the Y-axis direction of Fig. 4, and the second electrically conductive member 22 is able to smoothly cooperate with the first electrically conductive member 12 in a point-surface contact manner; and the first push member 15 is able to float in the first mounting base 14 in the Y-axis of Fig. 4, and the first push member 15 is able to smoothly cooperate with the first driving rod 231 in a point-surface contact manner, such that no interference exists between the first plug assembly 20 and the first receptacle assembly 10, and the first plug assembly 20 is able to be quickly plugged into the first receptacle assembly 10 in the X-axis direction, Y-axis direction, or any ray direction led from a vertex of an angle formed by the X-axis and Y-axis. Moreover, the second signal transmission member 42 is able to float in the fourth base 41 in the X-axis direction of Fig. 6, and the second signal transmission member 42 is able to smoothly cooperate with the first signal transmission member 32 in a point-surface contact manner; and the second push member 34 is able to float in the second mounting base 33 in the X-axis of Fig. 6, and the second push member 34 is able to smoothly cooperate with the second driving rod 431 in a point-surface contact manner, such that no interference exists between the second receptacle assembly 30 and the second plug assembly 40, and the second plug assembly 40 is able to be quickly plugged into the second receptacle assembly 30 in the X-axis direction, Y-axis direction, or any ray direction led from the vertex of the angle formed by the X-axis and Y-axis. In this way, the first plug assembly 20 and the first receptacle assembly 10 as well as the second receptacle assembly 30 and the second plug assembly 40 implement plug-in connection simultaneously, and the first display unit 51 is able to be quickly and accurately assembled onto the second display unit 52 and the fourth display unit 54 in the X-axis direction, the Y-axis direction or any ray direction led from the vertex of the angle formed by the X-axis and Y-axis.

In a similar way, during disassembly of the fourth display unit 54, the third display unit 53, the second display unit 52 and the first display unit 51 in the circumferential direction, the first plug assembly 20 is able to be quickly separated from the first receptacle assembly 10 in the X-axis direction, Y-axis direction, or any ray direction led from the vertex of the angle formed by the X-axis and Y-axis. The second plug assembly 40 is able to be quickly separated from the second receptacle assembly 30 in the X-axis direction, the Y-axis direction or any ray direction led from the vertex of the angle formed by the X-axis and Y-axis. In this way, the first plug assembly 20 and the first receptacle assembly 10 as well as the second receptacle assembly 30 and the second plug assembly 40 implement plug-out simultaneously, and the first display unit 51 is able to be quickly and accurately disassembled from the second display unit 52 and the fourth display unit 54 in the X-axis direction, the Y-axis direction or any ray direction led from the vertex of the angle formed by the X-axis and Y-axis. Furthermore, the fourth display unit 54, the third display unit 53, the second display unit 52, and the first display unit 51 may be connected wirelessly (without a flexible wire) and synchronous plugging and unplugging of the plug-in connection device in the X-axis and Y-axis directions is also realized.

Certainly, in an embodiment not shown in the figures, the second receptacle assembly of the plug-in connection device may be mounted on the side edge of the first display unit adjacent to the second display unit. The second plug assembly of the plug-in connection device may be mounted on the side edge of the second display unit adjacent to the first display unit.

It is to be noted that in order to further implement simultaneous plugging unplugging of the plug-in connection device in the X-axis and Y-axis directions, sufficient point-surface contact pressure needs to be guaranteed between the second electrically conductive member 22 and the first electrically conductive member 12, and sufficient point-surface contact pressure also needs to be guaranteed between the first push member 15 and the first driving rod 231, so as to guarantee stable transmission of power and signals. The force between the first plug assembly 20 and the first receptacle assembly 10 is designed in such way that the first push member 15 is pressed to the bottom with a maximum force being F1, and a minimum force of the first driving rod 231 is F2; and a force conversion ratio of the first lever plate 232 is N, a contact theoretical pressure between the second electrically conductive member 22 and the first electrically conductive member 12 is F3, a compression reverse pushing force of the first elastic member 25 is F4, and a gravitational force of the second electrically conductive member 22 is G1. In order to guarantee stable contact between the second electrically conductive member 22 with the first electrically conductive member 12, the force relation above is: 2F2 ≥ N (F3+F4+G1). The design of force between the second plug assembly 40 and the second receptacle assembly 30 has a principle consistent with the design of force between the first plug assembly 20 and the first receptacle assembly 10, and will not be repeated herein.

## Claims

1. A plug-in connection device for an LED display device, comprising a power supply plug-in connection structure, wherein the power supply plug-in connection structure comprises:
a first receptacle assembly (10) comprising a first base (11), and
a first electrically conductive member (12) arranged on the first base (11); and
a first plug assembly (20) comprising a second base (21), a second electrically conductive member (22) movably arranged on the second base (21), and a first driving member (23) movably arranged on the second base (21), wherein the second electrically conductive member (22) has a first connection position penetrating out of the second base (21) and being in contact conduction with the first electrically conductive member (12) and a first disconnection position retracted into the second base (21) and separated from the first electrically conductive member (12), and the first driving member (23) moves to drive the second electrically conductive member (22) to move towards or away from the first electrically conductive member (12) so as to make the second electrically conductive member (22) switch between the first connection position and the first disconnection position;
**characterized in that**, the first receptacle assembly (10) comprises a switch (13), wherein the switch (13) is able to make the first electrically conductive member (12) in a connected state or a disconnected state, and furthermore
the first electrically conductive member (12) comprises a printed circuit board (PCB) (121) mounted in the first base (11), and an input electrically conductive terminal (122) and an output electrically conductive terminal (123) arranged on the PCB (121);
the second electrically conductive member (22) comprises an insulating substrate (221) movably arranged on the second base (21), and an electrically conductive column (222) arranged in the insulating substrate (221), the electrically conductive column (222) is floatably arranged relative to the insulating substrate (221) in a moving direction of the insulating substrate (221), and the first driving member (23) moves to drive the insulating substrate (221) to move towards or away from the first electrically conductive member (12), so as to make the electrically conductive column (222) in contact conduction with or separated from the input electrically conductive terminal (122).

2. The plug-in connection device according to claim 1, wherein the input electrically conductive terminal (122) and the output electrically conductive terminal (123) are disconnected, the switch (13) comprises a connecting conductor arranged in the first base (11) and an operational key (131) driving the connecting conductor to move, and the connecting conductor connects the input electrically conductive terminal (122) with the output electrically conductive terminal (123) when moving to cooperate with both the input electrically conductive terminal (122) and the output electrically conductive terminal (123).

3. The plug-in connection device according to claim 2, wherein the first receptacle assembly (10) further comprises an external socket (124) arranged on the PCB (121), and the external socket (124) is electrically connected with the output electrically conductive terminal (123).

4. The plug-in connection device according to claim 2, wherein the first plug assembly (20) further comprises a guide structure arranged between the second base (21) and the insulating substrate (221), the guide structure comprises a guide hole (241) extending in the moving direction of the insulating substrate (221) and a guide column (242) capable of being inserted into the guide hole (241), one of the guide hole (241) and the guide column (242) is arranged on the second base (21), and the other of the guide hole (241) and the guide column (242) is arranged on the insulating substrate (221).

5. The plug-in connection device according to claim 1, wherein the first plug assembly (20) further comprises a first elastic member (25) arranged between the second base (21) and the second electrically conductive member (22), and the first elastic member (25) applies an elastic force in a direction away from the first base (11) to the second electrically conductive member (22); and/or, the second electrically conductive member (22) cooperates with the first electrically conductive member (12) in a point-surface contact manner when the second electrically conductive member (22) is at the first connection position.

6. The plug-in connection device according to claim 1, wherein the first receptacle assembly (10) further comprises a first push member (15) spaced apart from the first base (11), the first driving member (23) comprises a first driving rod (231) movably disposed on the second base (21) in a penetrating manner and a first lever plate (232) swingably arranged in the second base (21), a first end of the first lever plate (232) abuts against the first driving rod (231), a second end of the first lever plate (232) abuts against the second electrically conductive member (22), and the first push member (15) is movably arranged and is able to push the first driving rod (231) to move, so as to drive the first lever plate (232) to swing and to drive the second electrically conductive member (22) to switch from the first disconnection position to the first connection position.

7. The plug-in connection device according to claim 6, wherein the first receptacle assembly (10) further comprises a first mounting base (14) spaced apart from the first base (11), and a second elastic member (16) arranged in the first mounting base (14), the first push member (15) is movably located in the first mounting base (14), the second elastic member (16) applies an elastic force towards the first driving rod (231) to the first push member (15), and the first push member (15) is able to cooperate with the first driving rod (231) in a point-surface contact manner.

8. The plug-in connection device according to any of claims 1-7, further comprising a signal plug-in connection structure, wherein the signal plug-in connection structure comprises:
a second receptacle assembly (30) comprising a third base (31) and a first signal transmission member (32) arranged on the third base (31); and
a second plug assembly (40) comprising a fourth base (41), a second signal transmission member (42) movably arranged on the fourth base (41), and a second driving member (43) movably arranged on the fourth base (41),
wherein the second signal transmission member (42) has a second connection position penetrating out of the fourth base (41) and being in contact conduction with the first signal transmission member (32) and a second disconnection position retracted into the fourth base (41) and separated from the first signal transmission member (32), and the second driving member (43) moves to drive the second signal transmission member (42) to move towards or away from the first signal transmission member (32), so as to make the second signal transmission member (42) switch between the second connection position and the second disconnection position.

9. The plug-in connection device according to claim 8, wherein the second plug assembly (40) further comprises a third elastic member (44) arranged between the fourth base (41) and the second signal transmission member (42), and the third elastic member (44) applies an elastic force in a direction away from the third base (31) to the second signal transmission member (42); and/or, the second signal transmission member (42) cooperates with the first signal transmission member (32) in a point-surface contact manner when the second signal transmission member (42) is at the second connection position.

10. The plug-in connection device according to claim 8, wherein
the second receptacle assembly (30) further comprises a second push member (34) spaced apart from the third base (31), the second driving member (43) comprises a second driving rod (431) movably disposed on the fourth base (41) in a penetrating manner and a second lever plate (432) swingably arranged in the fourth base (41), a first end of the second lever plate (432) abuts against the second driving rod (431), a second end of the second lever plate (432) abuts against the second signal transmission member (42), and the second push member (34) is movably arranged and is able to push the second driving rod (431) to move, so as to drive the second lever plate (432) to swing and to drive the second signal transmission member (42) to switch from the second disconnection position to the second connection position; and
the second receptacle assembly (30) further comprises a second mounting base (33) spaced apart from the third base (31), and a fourth elastic member (35) arranged in the second mounting base (33), the second push member (34) is movably located in the second mounting base (33), the fourth elastic member (35) applies an elastic force towards the second driving rod (431) to the second push member (34), and the second push member (34) is able to cooperate with the second driving rod (431) in a point-surface contact manner.

11. An LED display device, comprising a first display unit (51), a second display unit (52) and a plug-in connection device, wherein the first display unit (51) and the second display unit (52) are arranged side by side, the plug-in connection device is the plug-in connection device for an LED display device according to any one of claims 1-10, the first receptacle assembly (10) of the plug-in connection device is mounted on a side edge of the first display unit (51) adjacent to the second display unit (52), and the first plug assembly (20) of the plug-in connection device is mounted on a side edge of the second display unit (52) adjacent to the first display unit (51).

12. An LED display device, comprising a first display unit (51), a second display unit (52), a third display unit (53), a fourth display unit (54) and a plug-in connection device, wherein the first display unit (51), the second display unit (52), the third display unit (53) and the fourth display unit (54) are arranged in an array and distributed sequentially in a circumferential direction, the plug-in connection device is the plug-in connection device for an LED display device according to any one of claims 8-10, the first receptacle assembly (10) of the plug-in connection device is mounted on a side edge of the first display unit (51) adjacent to the second display unit (52), and the first plug assembly (20) of the plug-in connection device is mounted on a side edge of the second display unit (52) adjacent to the first display unit (51);
the second receptacle assembly (30) of the plug-in connection device is mounted on the side edge of the first display unit (51) adjacent to the second display unit (52), and the second plug assembly (40) of the plug-in connection device is mounted on the side edge of the second display unit (52) adjacent to the first display unit (51); and/or,
the second receptacle assembly (30) of the plug-in connection device is mounted on a side edge of the first display unit (51) adjacent to the fourth display unit (54), and the second plug assembly (40) of the plug-in connection device is mounted on a side edge of the fourth display unit (54) adjacent to the first display unit (51).

## Patentansprüche

1. Steckverbindung für eine LED-Anzeigevorrichtung, mit einer Steckverbindung für die Stromversorgung, wobei die Steckverbindung für die Stromversorgung umfasst:
eine erste Steckverbinderbaugruppe (10) mit einer ersten Basis (11) und einem ersten elektrisch leitfähigen Element (12), das auf der ersten Basis (11) angeordnet ist; und
eine erste Steckerbaugruppe (20) mit einer zweiten Basis (21), einem zweiten elektrisch leitfähigen Element (22), das beweglich auf der zweiten Basis (21) angeordnet ist, und ein erstes Antriebselement (23), das beweglich auf der zweiten Basis (21) angeordnet ist, wobei das zweite elektrisch leitende Element (22) eine erste Verbindungsposition, in der es aus der zweiten Basis (21) herausragt und in Kontaktleitung mit dem ersten elektrisch leitenden Element (12) steht, und eine erste Trennposition aufweist, in der es in die zweite Basis (21) zurückgezogen und vom ersten elektrisch leitenden Element (12) getrennt ist (12) getrennt ist, und das erste Antriebselement (23) sich bewegt, um das zweite elektrisch leitfähige Element (22) anzutreiben, sich zum ersten elektrisch leitfähigen Element (12) hin oder von diesem weg zu bewegen, um das zweite elektrisch leitfähige Element (22) zwischen der ersten Verbindungsposition und der ersten Trennposition umzuschalten;
**dadurch gekennzeichnet, dass** die erste Steckverbinderanordnung (10) einen Schalter (13) umfasst, wobei der Schalter (13) das erste elektrisch leitende Element (12) in einen verbundenen Zustand oder einen getrennten Zustand versetzen kann, und ferner das erste elektrisch leitende Element (12) eine Leiterplatte (PCB) (121) umfasst, die in der ersten Basis (11) montiert ist, und einen elektrisch leitenden Eingangsanschluss (122) und einen elektrisch leitenden Ausgangsanschluss (123) umfasst, die auf der Leiterplatte (121) angeordnet sind;
das zweite elektrisch leitfähige Element (22) ein isolierendes Substrat (221), das beweglich auf der zweiten Basis (21) angeordnet ist, und eine elektrisch leitfähige Säule (222) umfasst, die in dem isolierenden Substrat (221) angeordnet ist, wobei die elektrisch leitfähige Säule (222) relativ zu dem isolierenden Substrat (221) in einer Bewegungsrichtung des isolierenden Substrats (221) beweglich angeordnet, und das erste Antriebselement (23) bewegt sich, um das isolierende Substrat (221) anzutreiben, sich auf das erste elektrisch leitfähige Element (12) zu oder von diesem weg zu bewegen, um die elektrisch leitfähige Säule (222) in Kontaktleitung mit dem elektrisch leitfähigen Eingangsanschluss (122) zu bringen oder von diesem zu trennen.

2. Steckverbindungsvorrichtung nach Anspruch 1, wobei der elektrische Eingangsanschluss (122) und der elektrische Ausgangsanschluss (123) getrennt sind, der Schalter (13) einen in der ersten Basis (11) angeordneten Verbindungsleiter und eine Betätigungstaste (131) umfasst, die den Verbindungsleiter antreibt, um sich zu bewegen, und der Verbindungsleiter den elektrischen Eingangsanschluss (122) mit dem elektrisch leitenden Ausgangsanschluss (123), wenn er sich bewegt, um sowohl mit dem elektrisch leitenden Eingangsanschluss (122) als auch mit dem elektrisch leitenden Ausgangsanschluss (123) zusammenzuwirken.

3. Steckverbindungsvorrichtung nach Anspruch 2, wobei die erste Steckverbinderbaugruppe (10) ferner eine auf der Leiterplatte (121) angeordnete externe Buchse (124) umfasst und die externe Buchse (124) elektrisch mit dem elektrisch leitenden Ausgangsanschluss (123) verbunden ist.

4. Steckverbindungsvorrichtung nach Anspruch 2, wobei die erste Steckbaugruppe (20) ferner eine Führungsstruktur umfasst, die zwischen der zweiten Basis (21) und dem isolierenden Substrat (221) angeordnet ist, wobei die Führungsstruktur ein Führungsloch (241), das sich in Bewegungsrichtung des isolierenden Substrats (221) erstreckt, und eine Führungssäule (242) umfasst, die in das Führungsloch (241) eingeführt werden kann (241) eingesetzt werden kann, wobei eines der Führungslöcher (241) und der Führungssäulen (242) auf der zweiten Basis (21) angeordnet ist und das andere der Führungslöcher (241) und der Führungssäulen (242) auf dem isolierenden Substrat (221) angeordnet ist.

5. Steckverbindungsvorrichtung nach Anspruch 1, wobei die erste Steckbaugruppe (20) ferner ein erstes elastisches Element (25) umfasst, das zwischen der zweiten Basis (21) und dem zweiten elektrisch leitfähigen Element (22) angeordnet ist, und das erste elastische Element (25) eine elastische Kraft in einer Richtung weg von der ersten Basis (11) auf das zweite elektrisch leitfähige Element (22) ausübt; und/oder das zweite elektrisch leitende Element (22) mit dem ersten elektrisch leitenden Element (12) in einer Punkt-Flächen-Kontaktweise zusammenwirkt, wenn sich das zweite elektrisch leitende Element (22) an der ersten Verbindungsposition befindet.

6. Steckverbindungsvorrichtung nach Anspruch 1, wobei die erste Aufnahmebaugruppe (10) ferner ein erstes Druckelement (15) umfasst, das von der ersten Basis (11) beabstandet ist, das erste Antriebselement (23) eine erste Antriebsstange (231), die beweglich auf der zweiten Basis (21) in einer durchdringenden Weise angeordnet ist, und eine erste Hebelplatte (232) umfasst, die schwenkbar in der zweiten Basis (21) angeordnet ist, wobei ein erstes Ende der ersten Hebelplatte (232) an der ersten Antriebsstange (231) anliegt, ein zweites Ende der ersten Hebelplatte (232) an dem zweiten elektrisch leitenden Element (22) an, und das erste Druckelement (15) ist beweglich angeordnet und kann die erste Antriebsstange (231) in Bewegung versetzen, um die erste Hebelplatte (232) zum Schwenken anzutreiben und das zweite elektrisch leitende Element (22) anzutreiben, um von der ersten Trennposition in die erste Verbindungsposition zu schalten.

7. Steckverbindungsvorrichtung nach Anspruch 6, wobei die erste Steckverbinderanordnung (10) ferner eine erste Montagebasis (14), die von der ersten Basis (11) beabstandet ist, und ein zweites elastisches Element (16) umfasst, das in der ersten Montagebasis (14) angeordnet ist, wobei das erste Druckelement (15) beweglich in der ersten Montagebasis (14) angeordnet ist, das zweite elastische Element (16) eine elastische Kraft in Richtung der ersten Antriebsstange (231) auf das erste Druckelement (15) ausübt und das erste Druckelement (15) in der Lage ist, mit der ersten Antriebsstange (231) in einer Punkt-Flächen-Kontaktweise zusammenzuwirken.

8. Steckverbindungsvorrichtung nach einem der Ansprüche 1 bis 7, die ferner eine Signalsteckverbindungsstruktur umfasst, wobei die Signalsteckverbindungsstruktur umfasst:
eine zweite Aufnahmebaugruppe (30) mit einer dritten Basis (31) und einem ersten Signalübertragungselement (32), das auf der dritten Basis (31) angeordnet ist; und
eine zweite Steckbaugruppe (40) mit einer vierten Basis (41), einem zweiten Signalübertragungselement (42), das beweglich auf der vierten Basis (41) angeordnet ist, und einem zweiten Antriebselement (43), das beweglich auf der vierten Basis (41),
wobei das zweite Signalübertragungselement (42) eine zweite Verbindungsposition, die aus der vierten Basis (41) herausragt und in Kontaktleitung mit dem ersten Signalübertragungselement (32) steht, und eine zweite Trennposition aufweist, die in die vierte Basis (41) zurückgezogen und vom ersten Signalübertragungselement (32) getrennt ist, und das zweite Antriebselement (43) sich bewegt, um das zweite Signalübertragungselement (42) anzutreiben, sich auf das erste Signalübertragungselement (32) zu oder von diesem weg zu bewegen, um das zweite Signalübertragungselement (42) zwischen der zweiten Verbindungsposition und der zweiten Trennposition umzuschalten.

9. Steckverbindungsvorrichtung nach Anspruch 8, wobei die zweite Steckbaugruppe (40) ferner ein drittes elastisches Element (44) umfasst, das zwischen der vierten Basis (41) und dem zweiten Signalübertragungselement (42) angeordnet ist, und das dritte elastische Element (44) eine elastische Kraft in einer Richtung weg von der dritten Basis (31) auf das zweite Signalübertragungselement (42) ausübt; und/oder das zweite Signalübertragungselement (42) mit dem ersten Signalübertragungselement (32) in einer Punkt-Flächen-Kontaktweise zusammenwirkt, wenn sich das zweite Signalübertragungselement (42) in der zweiten Verbindungsposition befindet.

10. Steckverbindungsvorrichtung nach Anspruch 8, wobei
die zweite Aufnahmebaugruppe (30) ferner ein zweites Druckelement (34) umfasst, das von der dritten Basis (31) beabstandet ist, das zweite Antriebselement (43) eine zweite Antriebsstange (431), die beweglich auf der vierten Basis (41) in einer durchdringenden Weise angeordnet ist, und eine zweite Hebelplatte (432) umfasst, die schwenkbar in der vierten Basis (41) angeordnet ist, ein erstes Ende der zweiten Hebelplatte (432) an der zweiten Antriebsstange (431) anliegt, ein zweites Ende der zweiten Hebelplatte (432) an dem zweiten Signalübertragungselement (42) anliegt und das zweite Druckelement (34) beweglich angeordnet ist und die zweite Antriebsstange (431) zum Bewegen drücken kann, um die zweite Hebelplatte
(432) zum Schwingen anzutreiben und das zweite Signalübertragungselement (42) anzutreiben, um von der zweiten Trennposition in die zweite Verbindungsposition zu schalten; und
die zweite Steckdosenanordnung (30) ferner eine zweite Montagebasis (33), die von der dritten Basis (31) beabstandet ist, und ein viertes elastisches Element (35) umfasst, das in der zweiten Montagebasis (33) angeordnet ist, wobei das zweite Druckelement (34) beweglich in der zweiten Montagebasis (33) angeordnet ist, das vierte elastische Element (35) eine elastische Kraft in Richtung der zweiten Antriebsstange (431) auf das zweite Druckelement (34) ausübt und das zweite Druckelement (34) in der Lage ist, mit der zweiten Antriebsstange (431) in einer Punkt-Flächen-Kontaktweise zusammenzuwirken.

11. LED-Anzeigevorrichtung, umfassend eine erste Anzeigeeinheit (51), eine zweite Anzeigeeinheit (52) und eine Steckverbindungsvorrichtung, wobei die erste Anzeigeeinheit (51) und die zweite Anzeigeeinheit (52) nebeneinander angeordnet sind, die Steckverbindungsvorrichtung die Steckverbindungsvorrichtung für eine LED-Anzeigevorrichtung gemäß einem der Ansprüche 1 bis 10 ist, die erste Aufnahmebaugruppe (10) der Steckverbindungsvorrichtung an einer Seitenkante der ersten Anzeigeeinheit (51) neben der zweiten Anzeigeeinheit (52) angebracht ist und die erste Steckbaugruppe (20) der Steckverbindungsvorrichtung an einer Seitenkante der zweiten Anzeigeeinheit (52) neben der ersten Anzeigeeinheit (51) angebracht ist.

12. LED-Anzeigevorrichtung, umfassend eine erste Anzeigeeinheit (51), eine zweite Anzeigeeinheit (52), eine dritte Anzeigeeinheit (53), eine vierte Anzeigeeinheit (54) und eine Steckverbindungsvorrichtung, wobei die erste Anzeigeeinheit (51), die zweite Anzeigeeinheit (52), die dritte Anzeigeeinheit (53) und die vierte Anzeigeeinheit (54) in einer Anordnung angeordnet und in Umfangsrichtung sequenziell verteilt sind, die Steckverbindungseinrichtung die Steckverbindungseinrichtung für eine LED-Anzeigevorrichtung gemäß einem der Ansprüche 8 bis 10 ist, die erste Aufnahmebaugruppe (10) der Steckverbindung an einer Seitenkante der ersten Anzeigeeinheit (51) neben der zweiten Anzeigeeinheit (52) angebracht ist und die erste Steckbaugruppe (20) der Steckverbindung an einer Seitenkante der zweiten Anzeigeeinheit (52) neben der ersten Anzeigeeinheit (51) angebracht ist;
die zweite Buchsenbaugruppe (30) der Steckverbindungsvorrichtung an der Seitenkante der ersten Anzeigeeinheit (51) neben der zweiten Anzeigeeinheit (52) angebracht ist und die zweite Steckerbaugruppe (40) der Steckverbindungsvorrichtung an der Seitenkante der zweiten Anzeigeeinheit (52) neben der ersten Anzeigeeinheit (51) angebracht ist; und/oder
die zweite Steckverbinderanordnung (30) der Steckverbindungsvorrichtung an einer Seitenkante der ersten Anzeigeeinheit (51) neben der vierten Anzeigeeinheit (54) angebracht ist und die zweite Steckverbinderanordnung (40) der Steckverbindungsvorrichtung an einer Seitenkante der vierten Anzeigeeinheit (54) neben der ersten Anzeigeeinheit (51) angebracht ist.

## Revendications

1. Dispositif de connexion enfichable pour un dispositif d'affichage à DEL, comprenant une structure de connexion enfichable d'alimentation électrique, dans lequel la structure de connexion enfichable d'alimentation électrique comprend:
un premier ensemble de réceptacle (10) comprenant une première base (11) et un premier élément électriquement conducteur (12) disposé sur la première base (11); et
un premier ensemble de fiche (20) comprenant une deuxième base (21), un deuxième élément électriquement conducteur (22) disposé de manière mobile sur la deuxième base (21), et un premier élément d'entraînement (23) disposé de manière mobile sur la deuxième base (21), dans lequel le deuxième élément électriquement conducteur (22) a une première position de connexion pénétrant hors de la deuxième base (21) et étant en contact conducteur avec le premier élément électriquement conducteur (12) et une première position de déconnexion rétractée dans la deuxième base (21) et séparée du premier élément électriquement conducteur (12), et le premier élément d'entraînement (23) se déplace pour entraîner le deuxième élément électriquement conducteur (22) à se déplacer vers ou à s'éloigner du premier élément électriquement conducteur (12) de manière à faire passer le deuxième élément électriquement conducteur (22) de la première position de connexion à la première position de déconnexion;
**caractérisé en ce que** le premier ensemble de réceptacle (10) comprend un commutateur (13), dans lequel le commutateur (13) est capable de mettre le premier élément électriquement conducteur (12) dans un état connecté ou un état déconnecté, et en outre, le premier élément électriquement conducteur (12) comprend une carte de circuit imprimé (PCB) (121) montée dans la première base (11), et une borne électriquement conductrice d'entrée (122) et une borne électriquement conductrice de sortie (123) disposées sur la carte de circuit imprimé (121);
le deuxième élément électriquement conducteur (22) comprend un substrat isolant (221) disposé de manière mobile sur la deuxième base (21), et une colonne électriquement conductrice (222) disposée dans le substrat isolant (221), la colonne électriquement conductrice (222) est disposée de manière flottante par rapport au substrat isolant (221) dans une direction de déplacement du substrat isolant (221), et le premier élément d'entraînement (23) se déplace pour entraîner le substrat isolant (221) à se déplacer vers ou à s'éloigner du premier élément électriquement conducteur (12), de manière à mettre la colonne électriquement conductrice (222) en conduction de contact avec ou à la séparer de la borne électriquement conductrice d'entrée (122).

2. Dispositif de connexion enfichable selon la revendication 1, dans lequel la borne électriquement conductrice d'entrée (122) et la borne électriquement conductrice de sortie (123) sont déconnectées, le commutateur (13) comprend un conducteur de connexion disposé dans la première base (11) et une touche opérationnelle (131) entraînant le conducteur de connexion à se déplacer, et le conducteur de connexion relie la borne électriquement conductrice d'entrée (122) à la borne de sortie électriquement conductrice (123) lorsqu'il se déplace pour coopérer à la fois avec la borne d'entrée électriquement conductrice (122) et la borne de sortie électriquement conductrice (123).

3. Dispositif de connexion enfichable selon la revendication 2, dans lequel le premier ensemble de réceptacle (10) comprend en outre une prise externe (124) disposée sur le circuit imprimé (121), et la prise externe (124) est connectée électriquement à la borne de sortie électriquement conductrice (123).

4. Dispositif de connexion enfichable selon la revendication 2, dans lequel le premier ensemble de fiche (20) comprend en outre une structure de guidage disposée entre la deuxième base (21) et le substrat isolant (221), la structure de guidage comprend un trou de guidage (241) s'étendant dans la direction de déplacement du substrat isolant (221) et une colonne de guidage (242) pouvant être insérée dans le trou de guidage (241), l'un des éléments parmi le trou de guidage (241) et la colonne de guidage (242) étant disposé sur la deuxième base (21), et l'autre des éléments parmi le trou de guidage (241) et la colonne de guidage (242) étant disposé sur le substrat isolant (221).

5. Dispositif de connexion enfichable selon la revendication 1, dans lequel le premier ensemble de fiche (20) comprend en outre un premier élément élastique (25) disposé entre la deuxième base (21) et le deuxième élément électriquement conducteur (22), et le premier élément élastique (25) applique une force élastique dans une direction s'éloignant de la première base (11) vers le deuxième élément électriquement conducteur (22) ; et/ou, le deuxième élément électriquement conducteur (22) coopère avec le premier élément électriquement conducteur (12) selon un mode de contact point-surface lorsque le deuxième élément électriquement conducteur (22) se trouve à la première position de connexion.

6. Dispositif de connexion enfichable selon la revendication 1, dans lequel le premier ensemble de réceptacle (10) comprend en outre un premier élément de poussée (15) espacé de la première base (11), le premier élément d'entraînement (23) comprend une première tige d'entraînement (231) disposée de manière mobile sur la deuxième base (21) de manière pénétrante et une première plaque de levier (232) disposée de manière pivotante dans la deuxième base (21), une première extrémité de la première plaque de levier (232) bute contre la première tige d'entraînement (231), une deuxième extrémité de la première plaque de levier (232) vient en butée contre le deuxième élément électriquement conducteur (22), et le premier élément de poussée (15) est disposé de manière mobile et est capable de pousser la première tige d'entraînement (231) pour la déplacer, de manière à entraîner la première plaque de levier (232) à pivoter et à entraîner le deuxième élément électriquement conducteur (22) à passer de la première position de déconnexion à la première position de connexion.

7. Dispositif de connexion enfichable selon la revendication 6, dans lequel le premier ensemble de réceptacle (10) comprend en outre une première base de montage (14) espacée de la première base (11), et un deuxième élément élastique (16) disposé dans la première base de montage (14), le premier élément de poussée (15) est situé de manière mobile dans la première base de montage (14), le deuxième élément élastique (16) applique une force élastique vers la première tige d'entraînement (231) sur le premier élément de poussée (15), et le premier élément de poussée (15) est capable de coopérer avec la première tige d'entraînement (231) par contact ponctuel.

8. Dispositif de connexion enfichable selon l'une quelconque des revendications 1 à 7, comprenant en outre une structure de connexion enfichable de signal, dans laquelle la structure de connexion enfichable de signal comprend :
un deuxième ensemble de réceptacle (30) comprenant une troisième base (31) et un premier élément de transmission de signal (32) disposé sur la troisième base (31); et
un deuxième ensemble de fiche (40) comprenant une quatrième base (41), un deuxième élément de transmission de signal (42) disposé de manière mobile sur la quatrième base (41), et un deuxième élément d'entraînement (43) disposé de manière mobile sur la quatrième base (41),
dans lequel le deuxième élément de transmission de signal (42) a une deuxième position de connexion pénétrant hors de la quatrième base (41) et étant en contact conducteur avec le premier élément de transmission de signal (32) et une deuxième position de déconnexion rétractée dans la quatrième base (41) et séparée du premier élément de transmission de signal (32), et le deuxième élément d'entraînement (43) se déplace pour entraîner le deuxième élément de transmission de signal (42) à se déplacer vers ou à s'éloigner du premier élément de transmission de signal (32), de manière à faire passer le deuxième élément de transmission de signal (42) de la deuxième position de connexion à la deuxième position de déconnexion.

9. Dispositif de connexion enfichable selon la revendication 8, dans lequel le deuxième ensemble de fiche (40) comprend en outre un troisième élément élastique (44) disposé entre la quatrième base (41) et le deuxième élément de transmission de signal (42), et le troisième élément élastique (44) applique une force élastique dans une direction s'éloignant de la troisième base (31) au deuxième élément de transmission de signal (42) ; et/ou, le deuxième élément de transmission de signal (42) coopère avec le premier élément de transmission de signal (32) selon un mode de contact point-surface lorsque le deuxième élément de transmission de signal (42) se trouve dans la deuxième position de connexion.

10. Dispositif de connexion enfichable selon la revendication 8, dans lequel
le deuxième ensemble de réceptacle (30) comprend en outre un deuxième élément de poussée (34) espacé de la troisième base (31), le deuxième élément d'entraînement (43) comprend une deuxième tige d'entraînement (431) disposée de manière mobile sur la quatrième base (41) de manière pénétrante et une deuxième plaque de levier (432) disposée de manière pivotante dans la quatrième base (41), une première extrémité de la deuxième plaque de levier (432) vient en butée contre la deuxième tige d'entraînement (431), une deuxième extrémité de la deuxième plaque de levier (432) vient en butée contre le deuxième élément de transmission de signal (42), et le deuxième élément de poussée (34) est disposé de manière mobile et est capable de pousser la deuxième tige d'entraînement (431) pour la déplacer, de manière à entraîner la deuxième plaque de levier (432) à pivoter et à entraîner le deuxième élément de transmission de signal (42) pour passer de la deuxième position de déconnexion à la deuxième position de connexion; et
le deuxième ensemble de réceptacle (30) comprend en outre une deuxième base de montage (33) espacée de la troisième base (31), et un quatrième élément élastique (35) disposé dans la deuxième base de montage (33), le deuxième élément de poussée (34) est situé de manière mobile dans la deuxième base de montage (33), le quatrième élément élastique (35) applique une force élastique vers la deuxième tige d'entraînement (431) sur le deuxième élément de poussée (34), et le deuxième élément de poussée (34) est capable de coopérer avec la deuxième tige d'entraînement (431) d'une manière de contact point-surface.

11. Dispositif d'affichage à LED, comprenant une première unité d'affichage (51), une deuxième unité d'affichage (52) et un dispositif de connexion enfichable, dans lequel la première unité d'affichage (51) et la deuxième unité d'affichage (52) sont disposées côte à côte, le dispositif de connexion enfichable est le dispositif de connexion enfichable pour un dispositif d'affichage à LED selon l'une quelconque des revendications 1 à 10, le premier ensemble de réceptacle (10) du dispositif de connexion enfichable est monté sur un bord latéral de la première unité d'affichage (51) adjacent à la deuxième unité d'affichage (52), et le premier ensemble de fiche (20) du dispositif de connexion enfichable est monté sur un bord latéral de la deuxième unité d'affichage (52) adjacent à la première unité d'affichage (51).

12. Dispositif d'affichage à LED, comprenant une première unité d'affichage (51), une deuxième unité d'affichage (52), une troisième unité d'affichage (53), une quatrième unité d'affichage (54) et un dispositif de connexion enfichable, dans lequel la première unité d'affichage (51), la deuxième unité d'affichage (52), la troisième unité d'affichage (53) et la quatrième unité d'affichage (54) sont disposées en réseau et réparties séquentiellement dans une direction circonférentielle, le dispositif de connexion enfichable est le dispositif de connexion enfichable pour un dispositif d'affichage à LED selon l'une quelconque des revendications 8 à 10, le premier ensemble de réceptacle (10) du dispositif de connexion enfichable est monté sur un bord latéral de la première unité d'affichage (51) adjacent à la deuxième unité d'affichage (52), et le premier ensemble de fiche (20) du dispositif de connexion enfichable est monté sur un bord latéral de la deuxième unité d'affichage (52) adjacent à la première unité d'affichage (51);
le deuxième ensemble réceptacle (30) du dispositif de connexion enfichable est monté sur le bord latéral de la première unité d'affichage (51) adjacente à la deuxième unité d'affichage (52), et le deuxième ensemble fiche (40) du dispositif de connexion enfichable est monté sur le bord latéral de la deuxième unité d'affichage (52) adjacente à la première unité d'affichage (51); et/ou,
le deuxième ensemble réceptacle (30) du dispositif de connexion enfichable est monté sur un bord latéral de la première unité d'affichage (51) adjacente à la quatrième unité d'affichage (54), et le deuxième ensemble fiche (40) du dispositif de connexion enfichable est monté sur un bord latéral de la quatrième unité d'affichage (54) adjacente à la première unité d'affichage (51).
